# EUROPÄISCHE PATENTANMELDUNG

(11) **EP 4 236 367 A1**
(43) Veröffentlichungstag der Anmeldung: **30.08.2023**
(21) Anmeldenummer: 22180187.1
(22) Anmeldetag: 21.06.2022
(51) Int. Cl.: H04R 7/14, B81C 1/00, H04R 17/00, H04R 19/00, H04R 31/00

(54) **KORRUGATIONEN ODER SCHWÄCHUNGSBEREICHE AUF ANKERSTRUKTUREN VON VERTIKALEN MEMS-WANDLER-MEMBRANEN**

(30) Priorität: 28.02.2022 EP 22159198
(71) Anmelder: Hahn-Schickard-Gesellschaft für angewandte Forschung e.V., 78052 Villingen-Schwenningen (DE)
(72) Erfinder: Becker, Dennis, 78166 Donaueschingen (DE); Dehé, Alfons, 72770 Reutlingen (DE)
(74) Vertreter: Hertin und Partner Rechts- und Patentanwälte PartG mbB

(57) **Zusammenfassung**

In einem ersten Aspekt betrifft die Erfindung einen MEMS-Wandler, welcher eine schwingfähige Membran zur Erzeugung oder Aufnahme von Druckwellen in eine vertikale Emissionsrichtung umfasst, wobei die schwingfähige Membran von einem Träger gehalten wird und die schwingfähige Membran vertikale Abschnitte aufweist, welche im Wesentlichen parallel zur Emissionsrichtung oder Aufnahmerichtung ausgebildet sind und mindestens eine Lage aus einem Aktuatormaterial umfassen. Die schwingfähige Membran liegt bevorzugt endseitig mit einer Elektrode kontaktiert vor, sodass durch Steuerung der Elektrode die vertikalen Abschnitte zu horizontalen Schwingungen anregbar sind oder sodass bei Anregung der vertikalen Abschnitte zu horizontalen Schwingungen an der Elektrode ein elektrisches Signal erzeugbar ist. Dabei weisen die vertikalen Abschnitte und/oder die horizontalen Abschnitte eine oder mehrere Korrugationen und/oder Schwächungsbereiche auf.

In einem weiteren Aspekt betrifft die Erfindung ein Verfahren zur Herstellung des erfindungsgemäßen MEMS-Wandlers.

## Beschreibung

### BESCHREIBUNG

In einem ersten Aspekt betrifft die Erfindung einen MEMS-Wandler, welcher eine schwingfähige Membran zur Erzeugung oder Aufnahme von Druckwellen in eine vertikale Emissionsrichtung umfasst, wobei die schwingfähige Membran von einem Träger gehalten wird und die schwingfähige Membran vertikale Abschnitte aufweist, welche im Wesentlichen parallel zur Emissionsrichtung oder Aufnahmerichtung ausgebildet sind und mindestens eine Lage aus einem Aktuatormaterial umfassen. Die schwingfähige Membran liegt bevorzugt endseitig mit einer Elektrode kontaktiert vor, sodass durch Steuerung der Elektrode die vertikalen Abschnitte zu horizontalen Schwingungen anregbar sind oder sodass bei Anregung der vertikalen Abschnitte zu horizontalen Schwingungen an der Elektrode ein elektrisches Signal erzeugbar ist. Dabei weisen die vertikalen Abschnitte und/oder die horizontalen Abschnitte eine oder mehrere Korrugationen und/oder Schwächungsbereiche auf.

In einem weiteren Aspekt betrifft die Erfindung ein Verfahren zur Herstellung des erfindungsgemäßen MEMS-Wandlers.

### Hintergrund und Stand der Technik

Für die Herstellung kompakter, mechanisch-elektronischer Vorrichtungen wird heute auf vielen Anwendungsgebieten auf die Mikrosystemtechnik zurückgegriffen. Die so herstellbaren Mikrosysteme (englisch microelectromechanical system, kurz MEMS) sind sehr kompakt (ca. im Mikrometerbereich) bei gleichzeitig hervorragender Funktionalität und immer geringeren Herstellungskosten.

Aus dem Stand der Technik sind auch MEMS-Wandler, wie beispielsweise MEMS-Lautsprecher oder MEMS-Mikrofone, bekannt. Derzeitige MEMS-Lautsprecher werden zumeist als planare Membransysteme ausgeführt mit einer vertikalen Aktuierung einer schwingfähigen Membran in Emissionsrichtung. Die Anregung erfolgt beispielsweise mittels piezoelektrischer, elektromagnetischer oder elektrostatischer Aktuatoren.

Ein elektromagnetischer MEMS-Lautsprecher für mobile Geräte wird in Shahosseini et al. 2015 beschrieben. Der MEMS-Lautsprecher weist eine versteifende Silizium-Mikrostruktur als Schallstrahler auf, wobei der bewegliche Teil an einem Träger über Silizium-Triebfedern aufgehangen wird, um große Verschiebungen mittels eines elektromagnetischen Motors aus der Ebene zu ermöglichen.

Stoppel et al. 2017 offenbart einen Zwei-Wege-Lautsprecher, dessen Konzept auf konzentrisch piezoelektrischen Aktuatoren basiert. Als eine Besonderheit ist die Schwingungsmembran nicht geschlossen ausgeführt, sondern umfasst acht piezoelektrische unimorphe Aktoren, die jeweils aus einer piezoelektrischen und einer passiven Schicht bestehen. Die äußeren Tieftöner bestehen aus vier einseitig eingespannten Aktuatoren mit Trapezform, während die inneren Hochtöner durch vier dreieckige Aktuatoren gebildet werden, welche mittels Federn mit einem starren Rahmen verbunden sind. Die Trennung der Membran soll ein verbessertes Klangbild bei höherer Leistung erlauben.

Nachteilig an derartigen planaren MEMS-Lautsprechern ist deren Limitierung in Bezug auf die mögliche Schallleistung, insbesondere bei tiefen Frequenzen. Ein Grund hierfür liegt darin, dass der erzeugbare Schalldruckpegel proportional zum Quadrat der Frequenz für eine vorgegebene Auslenkung ist. Für hinreichende Schallleistungen sind daher entweder Auslenkungen für die Schwingungsmembranen von mindestens 100 µm oder großflächige Membranen im Quadratzentimeterbereich notwendig. Beide Bedingungen sind mittels einer MEMS-Technologie nur schwer zu realisieren.

Im Stand der Technik wurde daher vorgeschlagen, MEMS-Lautsprecher zu konzipieren, welche nicht eine geschlossene Membran zu Schwingungen in vertikaler Emissionsrichtung aufweisen, sondern eine Vielzahl von beweglichen Elementen, die zu lateralen bzw. horizontalen Schwingungen angeregt werden können. Vorteilhaft hieran ist, dass auf kleiner Fläche ein vergrößerter Volumenstrom bewegbar und somit eine erhöhte Schallleistung bereitgestellt werden kann.

Ein auf diesem Prinzip basierender MEMS-Lautsprecher wird beispielsweise in der US 2018 / 0179048 A1 bzw. Kaiser et al. 2019 offenbart.

Der MEMS-Lautsprecher umfasst eine Mehrzahl von elektrostatischen Biegeaktuatoren, welche zwischen einem Deckel- und Boden-Wafer als vertikale Lamellen angeordnet vorliegen und durch entsprechende Steuerung zu lateralen Schwingungen angeregt werden können. Hierbei bildet eine innere Lamelle eine Aktuatorelektrode gegenüber zwei äußeren Lamellen. Bis auf einen Verbindungsknoten von weiterhin galvanisch getrennten Elektroden besteht ein Luftspalt zwischen den gebogenen drei Lamellen. Liegt ein Potential innen gegen außen an, führt dies zu einer beidseitigen Anziehung aufgrund der Wölbung des Designs in Richtung einer Vorzugsrichtung, welche durch einen Anker vorgegeben ist. Die Ausbuchtungen der äußeren Lamellen dienen der Beweglichkeit. Die Rückstellkraft ist durch eine mechanische Federkraft gegeben. Ein pull-push Betrieb ist somit nicht möglich.

Nachteilig ist zudem, dass Spalten zwischen den Biegeaktuatoren und den Deckel/Boden-Wafern, welche für deren Beweglichkeit notwendig sind, zu einer Ventilation zwischen beiden Kammern führen. Hierdurch erfährt die untere Grenzfrequenz eine Begrenzung. Weiterhin ist die laterale Bewegung der Biegeaktuatoren und mithin die Schallleistung eingeschränkt, um einen pull-in Effekt und akustischen Durchschlag zu vermeiden.

Ein alternatives Luftpuls- oder Schallerzeugungssystem auf MEMS-Basis wird in der US 2019 / 011 64 17 A1 beschrieben. Die Vorrichtung umfasst eine Vorder- sowie Rückkammer und eine Mehrzahl von Ventilen, wobei Vorder- und Rückkammer mittels einer gefalteten Membran voneinander getrennt sind. In einer Ausführungsform weist die gefaltete Membran im Querschnitt eine rechteckige Mäanderstruktur mit horizontalen und vertikalen Abschnitten auf. Auf den jeweiligen horizontalen Abschnitten sind Piezoaktuatoren positioniert, um durch eine synchronisierte Dehnung oder Stauchung der horizontalen Abschnitte eine laterale Bewegung der vertikalen Abschnitte zu bewirken. Bei dem vorgeschlagenen Prinzip kann ebenfalls auf einer kleinen Chip-Oberfläche ein vergrößerter Volumenstrom und somit eine höhere Schallleistung generiert werden.

Nachteilig ist jedoch der erhöhte Aufwand für den synchronisierten Antrieb der Piezoaktuatoren. Auch besteht ein Verbesserungspotential in Bezug auf das durch die lateralen Schwingungen verdrängte Volumen, welche durch die geometrische Anordnung der einseitig aktuierten horizontalen Abschnitte begrenzt ist.

In der WO 2021 / 144400 A1 wird ein MEMS-Wandler offenbart, der sowohl als MEMS-Lautsprecher als auch als MEMS-Mikrofon eingesetzt werden kann. Der darin beschriebene MEMS-Wandler weist eine schwingfähige Membran auf, die derart aufgebaut ist, dass sie zwei oder mehr vertikale Abschnitte umfasst, welche im Wesentlichen parallel zur vertikalen Richtung ausgebildet sind. Weiterhin umfasst die schwingfähige Membran mindestens eine Lage aus einem Aktuatormaterial und ist zumindest mit einer Elektrode endseitig kontaktiert. Hierdurch können über eine Ansteuerung der Elektrode die vertikalen Abschnitte zu horizontalen Schwingungen angeregt werden. Umgekehrt kann auch bei einer Anregung der vertikalen Abschnitte zu horizontalen Schwingungen an der Elektrode ein elektrisches Signal erzeugt werden.

Der in der WO 2021 / 144400 A1 offenbarte MEMS-Wandler weist deutliche Verbesserungen gegenüber dem Stand der Technik auf. Die Gestaltung der schwingfähigen Membran umfassend die vertikalen Abschnitte führt im Falle eines MEMS-Lautsprechers vorteilhaft zu einer höheren Schallleistung, wobei die Kontaktierung gleichzeitig eine vereinfachte Ansteuerbarkeit gewährleistet. Auch im Falle eines MEMS-Mikrofons wird vorteilhaft eine höhere Leistungsfähigkeit sowie Audioqualität mit einem geeigneten Klangbild ermöglicht. Zudem kann für die Herstellung des MEMS-Wandlers auf bewährte Prozesse der Halbleiterprozessierung zurückgegriffen werden, sodass eine kosteneffiziente Produktion ermöglicht wird.

Auch wenn der in der WO 2021 / 144400 A1 offenbarte MEMS-Wandler eine fortschrittliche Weiterentwicklung des Standes der Technik darstellt, liegt in Bezug auf die Leistungsfähigkeit und das Klangverhalten ein Potential an Optimierung vor.

Im Lichte des Standes der Technik besteht mithin weiterhin ein Bedarf an der Bereitstellung verbesserter MEMS-Wandler bzw. Verfahren zu deren Herstellung.

### Aufgabe der Erfindung

Aufgabe der Erfindung ist es, einen MEMS-Wandler sowie ein Verfahren zur Herstellung des MEMS-Wandlers bereitzustellen, welche die Nachteile des Standes der Technik nicht aufweisen. Insbesondere war es eine Aufgabe der Erfindung, einen MEMS-Wandler mit hoher Leistungsfähigkeit und Klangqualität zur Verfügung stellen, welcher sich gleichzeitig durch einen einfachen, kostengünstigen und kompakten Aufbau auszeichnet.

### Zusammenfassung der Erfindung

Die Aufgabe der Erfindung wird durch die Merkmale der unabhängigen Ansprüche gelöst. Bevorzugte Ausführungsformen der Erfindung sind in den abhängigen Ansprüchen beschrieben. In einem ersten Aspekt betrifft die Erfindung bevorzugt einen MEMS-Wandler zur Interaktion mit einem Volumenstrom eines Fluids umfassend einen Träger und eine schwingfähige Membran zur Erzeugung oder Aufnahme von Druckwellen des Fluids in einer vertikalen Richtung, welche an dem Träger befestigt und mit mindestens einer Elektrode kontaktiert vorliegt,
wobei die schwingfähige Membran vertikale Abschnitte und horizontale Abschnitte aufweist, wobei die vertikalen Abschnitte im Wesentlichen parallel zur vertikalen Richtung ausgebildet sind und die horizontalen Abschnitte die vertikalen Abschnitte miteinander verbinden,
sodass durch Ansteuerung der mindestens einen Elektrode die vertikalen Abschnitte zu horizontalen Schwingungen anregbar sind oder sodass bei Anregung der vertikalen Abschnitte zu horizontalen Schwingungen an der Elektrode ein elektrisches Signal erzeugbar ist, dadurch gekennzeichnet, dass die vertikalen Abschnitte und/oder die horizontalen Abschnitte eine oder mehrere Korrugationen und/oder Schwächungsbereiche aufweisen.

Der MEMS-Wandler kann in bevorzugten Ausführungsformen ein MEMS-Lautsprecher oder ein MEMS-Mikrofon sein. Durch die Konstruktionsweise des MEMS-Wandlers kann gleichermaßen für die Anwendung als MEMS-Lautsprecher sowie als MEMS-Mikrofon eine Reihe von Vorteilen erzielt werden.

Insbesondere kann ein MEMS-Lautsprecher mit hoher Schalleistung und vereinfachter Ansteuerung erhalten werden. Im Gegensatz zu bekannten planaren MEMS-Lautsprechen muss die schwingfähige Membran selbst nicht über eine große Fläche von mehreren Quadratzentimeter oder mit einer hohen Auslenkung betrieben werden, um einen ausreichenden Schalldruck zu erzeugen. Stattdessen kann die Mehrzahl der vertikalen Abschnitte der schwingfähigen Membran mit kleinen horizontalen bzw. lateralen Bewegungen von wenigen Mikrometer ein vergrößertes Gesamtvolumen in vertikaler Emissionsrichtung bewegen.

Gleichzeitig kann eine vereinfachten Ansteuerung erreicht werden. Während im Stand der Technik, wie u.a. in der US 2019 / 011 64 17 A1, eine Vielzahl von piezoelektrischen Aktuatoren an den horizontalen Abschnitten kontaktiert werden müssen, kann der hier beschriebene MEMS-Lautsprecher mittels mindestens einer vorzugsweise endseitigen Elektrode betrieben werden. Dies reduziert den Herstellungsaufwand, minimiert Fehlerquellen und führt zudem inhärent zu einer synchronen Steuerung der vertikalen Abschnitte zu horizontalen Schwingungen.

Auf diese Weise können die Luftvolumina, welche zwischen den vertikalen Abschnitten vorliegen, überaus präzise durch die horizontalen Schwingungen entlang der vertikalen Emissionsrichtung bewegt werden.

Ebenso wird auf diese Weise die Bereitstellung eines besonders leistungsstarken MEMS-Mikrofones mit hoher Audioqualität ermöglicht. Der Aufbau des MEMS-Mikrofons ähnelt strukturell dem des MEMS-Lautsprechers insbesondere im Hinblick auf die Ausgestaltung der schwingfähigen Membran. Anstelle einer Ansteuerung der Elektroden zur Erzeugung von horizontalen Schwingungen und mithin Schalldruckwellen, ist das MEMS-Mikrofon jedoch dafür ausgelegt, Schalldruckwellen in selbiger vertikaler Richtung aufzunehmen. Bevorzugt liegen zwischen den vertikalen Abschnitten mithin Luftvolumina vor, welche bei der Aufnahme von Schallwellen entlang einer vertikalen Detektionsrichtung bewegt werden. Durch die Schalldruckwellen werden die vertikalen Abschnitte zu horizontalen Schwingungen angeregt, sodass das Aktuatormaterial ein entsprechendes periodisches elektrisches Signal erzeugt.

Für das Schwingverhalten der Membran haben sich sowohl im Hinblick auf Anwendungen als MEMS-Lautsprecher als auch als MEMS-Mikrofon die Anbringung von Korrugationen und/oder von Schwächungsbereichen an den vertikalen und/oder horizontalen Abschnitten als überaus vorteilhaft erwiesen.

Erfindungsgemäß wurde erkannt, dass Korrugationen und/oder Schwächungsbereiche eine höheren Rotationsgrad der vertikalen Abschnitte ermöglichen, wodurch eine besonders effiziente Auslenkbarkeit der Membran während der Erzeugung oder Aufnahme von Druckwellen des Fluids gewähreistet wird. Insbesondere führen die Korrugationen und/oder Schwächungsbereiche dazu, dass bei der Erzeugung oder Aufnahme von Druckwellen die vertikalen Abschnitte eine besonders definierte Wölbung erfahren und potentiell unregelmäßige Knickungen (*,buckling'*) besonders wirksam verhindert werden.

Bei der Erzeugung oder Aufnahme von Druckwellen können die vertikalen Abschnitte mithin noch effektiver zu horizontalen Schwingungen angesteuert oder angeregt werden, um die Leistungsfähigkeit des MEMS-Wandlers zu optimieren.

Diesbezüglich ist es von weiterem Vorteil, dass die Korrugationen und/oder Schwächungsbereiche höhere Amplituden der horizontalen Schwingungen der vertikalen Abschnitte erlauben.

Hierdurch kommt es beispielsweise im Falle eines MEMS-Lautsprechers zu einer höheren Verdrängung des Fluidvolumens zwischen den vertikalen Abschnitten, wodurch eine Steigerung des erzeugten Schalldruckpegels ermöglicht wird. Mithin wird eine weitere Verbesserung in Bezug auf die Schallleistung, insbesondere auf den Schalldruckpegel gegenüber vorherigen Ansätzen erlangt. Entsprechend kann im Falle eines MEMS-Mikrofons mehr Fluidvolumen zwischen den vertikalen Abschnitten aufgenommen werden und eine Sensitivität des Schalldetektors erhöht werden.

Weiterhin ist es von Vorteil, dass eine besonders gleichmäßige Wölbung der vertikalen Abschnitte in beiden Richtungen der horizontalen Schwingungen ermöglicht wird. Hierdurch können harmonische Verzerrungen, insbesondere die THD (englisch *total harmonic disorder)* verringert werden. Die THD gibt bevorzugt das Verhältnis der summierten Leistungen aller Oberschwingungen zur Leistung der Grundschwingung einer schwingfähigen Membran an. Folglich wird durch eine Verringerung der THD die Summe der Oberschwingungen und mithin Verzerrungen des Messsignals oder des erzeugbares Signales verringert. Ein besonders gutes Klangbild resultiert sowohl bei der Aufnahme als auch bei der Erzeugung von Druckwellen des Fluids.

Durch die Einbringung von Unregelmäßigkeiten in Form von Korrugationen und/oder Schwächungsbereichen in die schwingfähige Membran wird mithin auf überraschende Weise deren Schwingungsverhalten nicht verzerrt, sondern vielmehr harmonisiert.

Die vorteilhaften Wirkungen können teilweise darauf zurückgeführt werden, dass mittels der Korrugationen und/oder Schwächungsbereiche eine Steifigkeit der jeweiligen Abschnitte der schwingfähigen Membran einstellbar ist. Beispielsweise wurde erfindungsgemäß erkannt, dass zu steif ausgebildete horizontale Abschnitte die Beweglichkeit der vertikalen Abschnitte nachteilig behindern und zu Unregelmäßigkeiten in deren Auslenkung bzw. Wölbung während horizontaler Schwingungen führen können. Durch eine gezielte Positionierung von Korrugationen und/oder Schwächungsbereichen, insbesondere in den horizontalen Abschnitten, wird deren Steifigkeit verringert und eine Auslenkbarkeit bzw. Rotationsfreiheit der vertikalen Abschnitte gesteigert.

So kann vorteilhaft durch eine Ausgestaltung der Korrugationen und/oder der Schwächungsbereiche, insbesondere hinsichtlich Geometrie, Breite und/oder Tiefe, die Steifigkeit und damit die Auslenkbarkeit eingestellt und je nach Anwendungszweck angepasst werden.

Dabei wurde festgestellt, dass sowohl Korrugationen als auch Schwächungsbereiche die obig erläuterten vorteilhaften technischen Effekte zur Folge haben. Mithin kann neben einer Ausgestaltung der Korrugationen auch durch bevorzugte Ausführungsformen der Schwächungsbereiche, beispielsweise hinsichtlich einer Variation von Schichtdicken, Anzahl oder Positionierung, das Schwingungsverhalten der schwingfähigen Membran des MEMS-Wandlers optimiert werden.

Darüber hinaus ist die Bereitstellung von Korrugationen und/oder Schwächungsbereichen mit bekannten Techniken, Prozessschritten und/oder Verfahren der Halbleiter- und Mikrosystemtechnik möglich, die sich im Stand der Technik als besonders effektiv etabliert haben. Damit ist die Applikation von Korrugationen und/oder Schwächungsbereichen an den vertikalen und/oder horizontalen Abschnitten vorteilhafterweise prozesseffizient möglich.

Eine Korrugation bezeichnet bevorzugt eine Abweichung von einem Verlauf eines Teilabschnitt der schwingfähigen Membran, wobei es sich vorzugsweise um eine Vertiefung oder Erhebung in einem ansonsten im Wesentlichen planplanaren Verlauf des Teilabschnitts handelt. In einer Querschnittsansicht der schwingfähigen Membran kennzeichnet eine Korrugation vorzugsweise eine Abweichung von einem kontinuierlichen, vorzugsweise geradlinigen Verlauf eines Teilbereiches (z.B. eines horizontalen und/oder vertikalen Teilbereiches). So kann beispielsweise mit einer Korrugation eine Rille bzw. Furche oder ein Steg gemeint sein, d. h. insbesondere eine Vertiefung oder Erhebung in den vertikalen und/oder den horizontalen Abschnitten. Diese Korrugationen, können eine Vielzahl von Ausgestaltungen hinsichtlich Geometrie, Tiefe, Breite und/oder Aspektverhältnis haben.

Ein Schwächungsbereich bezeichnet bevorzugt eine Verringerung einer Dicke einer Lage bzw. einer Schicht der schwingfähigen Membran. Bevorzugt beziehen sich Schwächungsbereiche auf Dicken der Lagen, welche die vertikalen und/oder die horizontalen Abschnitte bereitstellen. Beispielsweise können die horizontalen Abschnitte und/oder vertikalen Abschnitte mehrlagig ausgebildet sein und wobei eine oder mehrere Schwächungsbereiche durch eine Variation der Schichtdicke mindestens einer Lage bewirkt wird. Bevorzugt wird die Schichtdicke der mindestens einen Lage (z. B. einer Aktuatorlage, der Lage einer elektrisch leitfähigen Schicht bzw. einer Top- oder Bottom-Elektrode oder einer mechanischen Stützschicht) auf weniger als 70%, vorzugweise weniger als 60%, 50%, 40% oder weniger einer Ausgangsschichtdicke reduziert. Ein Schwächungsbereich kann auch durch eine Reduzierung einer Schichtdicke mindestens einer Lage auf 30 %, 20 % oder 10% oder weniger einer Ausgangsschichtdicke meinen. Die Begriffe "Schicht" und "Lage" können im erfindungsgemäßen Kontext synonym verwandt werden.

Ebenfalls kann es bevorzugt sein, dass ein Schwächungsbereich einer Reduktion einer Schichtdicke mindestens einer Lage auf 0 % einer Ausgangsschichtdicke entspricht. So kann es bevorzugt sein, dass ein Schwächungsbereich durch das Fehlen der mindestens einen Lage in einem Teilbereich der Membran gekennzeichnet ist. Vorzugsweise ist ein Schwächungsbereich durch eine Reduzierung einer Schichtdicke mindestens einer Lage (in einigen Ausführungsformen auf 0 %) gekennzeichnet, wobei mindestens eine andere Lage in dem Schwächungsbereich keine Reduktion der Schichtdicke gegenüber einer Ausgangsschichtdicke aufweist. In einigen Ausführungsformen kann ein Schwächungsbereich jedoch auch durch eine Reduzierung der Schichtdicke sämtlicher Lagen der Membran gekennzeichnet sein, bis hin zum Fehlen sämtlicher Lagen in einem Teilbereich. Im letzteren Fall wird ein Schwächungsbereich bevorzugt durch eine Öffnung in der Membran gebildet.

Weiterhin kann es auch bevorzugt sein, dass ein Schwächungsbereich sich durch einen Austausch der mindestens einen Lage gegen eine andere Lage (d.h. eine Lage umfassend ein anderes Material) auszeichnet. Beispielsweise kann ein Schwächungsbereich dadurch gebildet werden, dass ein Aktuatormaterial in einem Teilbereich gegen ein Nicht-Aktuatormaterial oder Isolationsmaterial, bevorzugt eine Isolationsschicht bzw. Isolationslage, ausgetauscht wird. Wie im Folgenden detaillierter aufgezeigt, kann ein Schwächungsbereich mithin sowohl durch eine Schwächung der mechanischen Eigenschaften eines Teilbereiches (z. B. Reduktion einer Steifigkeit) als auch durch eine Schwächung einer funktionellen Eigenschaft, z. B. der Fähigkeit, zu einer Formänderung durch Anlegen eines Signales angeregt zu werden.

Bevorzugt können Schwächungsbereiche und Korrugationen in Kombination miteinander an der Membran vorliegen. Beispielsweise kann es bevorzugt sein, dass ein Schwächungsbereich entlang eines Teilabschnitts der Membran vorliegt, an dem ebenfalls eine Korrugation angebracht ist, wobei der Teilabschnitt beispielsweise ein vertikaler und/oder ein horizontaler Abschnitt der Membran ist. Ebenso kann es bevorzugt sein, dass ein Schwächungsbereich an bzw. innerhalb einer Korrugation vorliegt. D. h. es kann bevorzugt sein, dass innerhalb einer Korrugation ein Schwächungsbereich beispielsweise in Form der Reduktion einer Schichtdicke mindestens einer Lage gegenüber einer Ausgangsschichtdicke (in einigen Fällen auf 0 %) vorliegt. Ebenso kann es bevorzugt sein, dass eine Korrugation innerhalb eines Schwächungsbereiches vorliegt. D. h. der Schwächungsbereich kann sich beispielsweise über einen Teilabschnitt der Membran erstrecken, wobei zusätzlich innerhalb des geschwächten Teilabschnittes eine Korrugation, wie obig beschrieben, eingebracht ist.

Sowohl Schwächungsbereiche als auch Korrugationen zeichnen sich bevorzugt dadurch aus, dass sie hinsichtlich der funktionellen und/oder mechanischen Eigenschaften der Teilabschnitte der schwingfähigen Membran eine Abweichung bzw. Inhomogenität darstellen, welche jedoch bewusst eingebracht wird. Die Erfinder haben erkannt, dass durch gezielte Einbringung von Korrugationen und/oder Schwächungsbereichen in horizontale und/oder vertikale Abschnitte eine Auslenkbarkeit der vertikalen Abschnitte und damit das Schwingungsverhalten der schwingfähigen Membran erheblich verbessert werden kann.

Vorzugsweise zeichnet sich ein Schwächungsbereich mithin durch eine Veränderung von funktionellen und/oder mechanischen Eigenschaften eines Teilabschnitts bzw. Teilbereiches der Membran aus.

Mit einer funktionellen Eigenschaft kann bevorzugt eine Anpassung der Aktuierbarkeit des Teilabschnitts gemeint sein, sodass insbesondere am Schwächungsbereich ein schwächere Aktuierung erfolgt als an Teilabschnitten der Membran, die keinen Schwächungsbereich aufweisen. Zu diesem Zweck kann es bevorzugt sein, dass im Schwächungsbereich die Schichtdicke der Aktuatorlage reduziert wird oder gänzlich fehlt. Ebenso kann es bevorzugt sein, dass eine für die Ansteuerung der Aktuatorlage notwendig Lage, wie beispielsweise eine Lage eines leitfähigen Materials, bereichsweise fehlt oder nur reduziert vorliegt.

Im Falle einer Aktuatorlage, welche aus einem piezoelektrischen Material gebildet wird, kann eine schwächere Aktuierbarkeit beispielsweise durch die Verringerung des Auftretens eines piezoelektrischen Effektes an einem Teilabschnitt der Membran gewährleistet werden. Beispielsweise kann es bevorzugt sein, in dem Teilabschnitt zwischen einer piezoelektrischen Aktuatorlage eine dielektrische Isolationsschicht einzubringen oder eine ansteuernde Top- oder Bottom-Elektrode bereichsweise auszulassen. Während der Anregung der Membran zu Schwingungen wird die Aktuatorlage mithin im Schwächungsbereich keine oder nur eine verringerte Spannungs- oder Formänderung erfahren. Durch eine derart bewusst eingebrachte Unregelmäßigkeit in der Aktuierung der Bereiche kann das Auftreten eines *Buckling* oder anderer Verzerrungen überraschend effektiv verhindert werden. Insbesondere die vertikalen Abschnitte können eine erhöhte Beweglichkeit aufweisen und harmonisch - ohne Verzerrung - schwingen.

Ebenso kann sich ein Schwächungsbereich durch eine Veränderung, insbesondere eine Verringerung, mechanischer Eigenschaften der Membran im betreffenden Teilabschnitt auszeichnen. Mit den mechanischen Eigenschaften ist beispielsweise eine Steifigkeit gemeint, d. h. einer Eigenschaft einer Formänderung mechanisch zu widerstehen. Vorzugsweise können mechanische Eigenschaften eines Schwächungsbereiches beispielsweise durch eine Verringerung der Schichtdicke einer mechanischen Stützlage bewirkt werden oder durch den Austausch einer Lage eines mechanischen Stützmaterials gegen ein Material mit einer geringeren Steifigkeit (bzw. eines höheren Elastizitätsmodules) gekennzeichnet sein. Die bereichsweise Schwächung der mechanischen Eigenschaften, wie einer Steifigkeit der Membran, führt vorteilhaft ebenfalls zur einer Optimierung des Auslenkungsverhaltens der Membran, in dem die Beweglichkeit der vertikalen Abschnitte erhöht und unerwünschte Effekte wie ein *Buckling* vermieden werden.

Die Richtungsangaben vertikal und horizontal hinsichtlich des MEMS-Wandlers bzw. der Membran beziehen sich bevorzugt auf eine Vorzugsrichtung, in welcher die schwingfähige Membran zur Erzeugung oder Aufnahme von Druckwellen des Fluids ausgerichtet ist. Bevorzugt ist die schwingfähige Membran horizontal zwischen mindestens zwei Seitenbereichen eines Trägers aufgehangen, während die vertikale Richtung (Interaktionsrichtung mit dem Fluid) zur Erzeugung oder Aufnahme von Druckwellen orthogonal dazu vorliegt.

In bevorzugten Ausführungsformen stellt der MEMS-Wandler ein MEMS-Lautersprecher oder ein MEMS-Mikrofon dar. Unter dem Begriff MEMS-Wandler ist somit sowohl ein MEMS-Mikrofon als auch ein MEMS-Lautsprecher zu verstehen. Allgemein bezeichnet der MEMS-Wandler einen Wandler zur Interaktion mit einem Volumenstrom eines Fluids, der auf MEMS-Technologie basiert und dessen Strukturen zur Interaktion mit dem Volumenstrom bzw. zur Aufnahme oder Erzeugung von Druckwellen des Fluids eine Dimensionierung im Mikrometerbereich (1 µm bis 1000 µm) aufweisen. Bei dem Fluid kann es sich sowohl um ein gasförmiges als auch um ein flüssiges Fluid handeln. Die Strukturen des MEMS-Wandlers, insbesondere der schwingfähigen Membran, sind zur Erzeugung oder Aufnahme von Druckwellen des Fluids ausgelegt.

Beispielsweise kann es sich, wie im Falle eines MEMS-Lautsprechers oder MEMS-Mikrofons, um Schalldruckwellen handeln. Der MEMS-Wandler kann sich aber ebenso als Aktuator oder Sensor für andere Druckwellen eignen. Der MEMS-Wandler ist somit bevorzugt ein Gerät, welches Druckwellen (z. B. akustische Signale als Schallwechseldrücke) in elektrische Signale umwandelt oder umgekehrt (Umwandlung elektrischer Signale in Druckwellen, beispielsweise akustische Signale).

Im Falle eines MEMS-Lautsprechers entspricht die vertikale (Interaktions-)Richtung der vertikalen Schallemissionsrichtung des MEMS-Lautsprechers. Vertikal meint in dem Fall bevorzugt die Richtung der Schallemission, während horizontal eine dazu orthogonale Richtung meint.

Im Falle eines MEMS-Mikrofons entspricht die vertikale (Interaktions-)Richtung der vertikalen Schalldetektionsrichtung des MEMS-Mikrofons. Vertikal meint in dem Fall bevorzugt die Richtung der Schalldetektion bzw. Aufnahme, während horizontal eine dazu orthogonale Richtung meint.

Die vertikalen Abschnitte der schwingfähigen Membran bezeichnen somit bevorzugt Abschnitte der schwingfähigen Membran, welche im Wesentlichen in Emissionsrichtung eines MEMS-Lautsprechers bzw. Detektionsrichtung eines MEMS-Mikrofons ausgerichtet sind. Der Fachmann versteht, dass es sich nicht um eine exakte vertikale Ausrichtung handeln muss, sondern bevorzugt die vertikalen Abschnitte der schwingfähigen Membran im Wesentlichen in Emissionsrichtung eines MEMS-Lautsprechers bzw. Detektionsrichtung eines MEMS-Mikrofons ausgerichtet sind.

In einer bevorzugten Ausführungsform sind die vertikalen Abschnitte im Wesentlichen parallel zur vertikalen Richtung ausgerichtet, wobei im Wesentlichen parallel einen Toleranzbereich von ± 30°, bevorzugt ± 20°, besonders bevorzugt ± 10° um die vertikale Richtung meint.

Die schwingfähige Membran kann mithin bevorzugt im Querschnitt nicht nur eine rechteckige Mäanderform, sondern ebenso eine kurvige bzw. wellige Form oder eine Sägezahnform (Zick-Zack-Form) aufweisen.

Vorzugsweise sind die vertikalen und/oder horizontalen Abschnitte mindestens abschnittsweise oder über deren gesamte Länge geradlinig, die vertikalen und/oder horizontalen Abschnitte können jedoch auch mindestens abschnittsweise oder über deren gesamte Länge kurvig ausgestaltet sein. Im Falle einer kurvigen Form der schwingfähigen Membran im Querschnitt bezieht sich die Ausrichtung bevorzugt auf eine Tangente an den kurvenförmigen vertikalen und/oder horizontalen Abschnitte an deren jeweiligen Mittelpunkten.

Während die schwingfähige Membran bevorzugt horizontal zur Schallemissionsrichtung oder Schalldetektionsrichtung ausgerichtet vorliegt, werden die Schallwellen durch eine Aktuierung der vertikalen Abschnitte erzeugt oder umgekehrt detektiert.

In einer bevorzugten Ausführungsform der Erfindung umfasst der Träger zwei Seitenbereiche zwischen welchen die schwingfähige Membran in horizontaler Richtung angeordnet vorliegt.

Bei dem Träger handelt es sich bevorzugt um eine Rahmenstruktur, welche im Wesentlichen durch eine durchgehende äußere Umrandung in Form von Seitenwänden eines freibleibenden flächigen Bereichs gebildet wird. Die Rahmenstruktur ist dabei bevorzugt stabil und biegesteif. Bei einer eckigen Rahmenform (dreieckiger, viereckiger, sechseckig oder allgemein mehreckiger Umriss) werden die einzelnen Seitenbereiche, die die Rahmenstruktur bevorzugt im Wesentlichen bilden, insbesondere Seitenwände genannt.

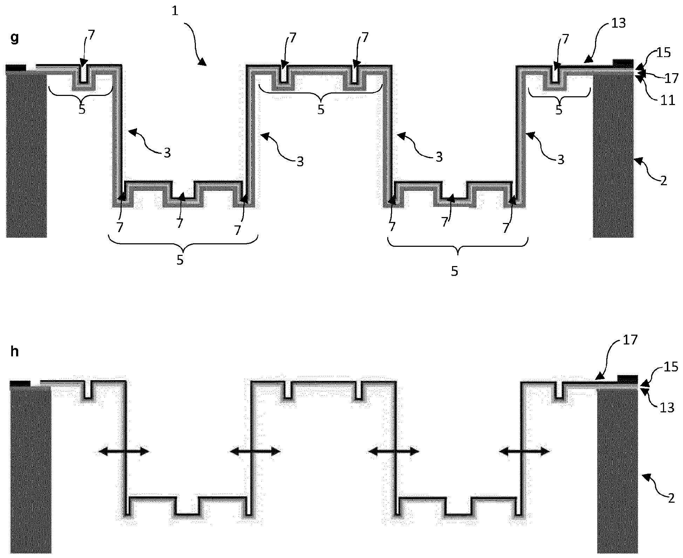

Die schwingfähige Membran wird bevorzugt von mindestens zwei Seitenwänden des Trägers gehalten. In der beispielhaften Fig. 2h sind die beiden Seitenwände im Querschnitt zu sehen. Bevorzugt umfasst der Träger jedoch vier Seitenbereiche, vorzugsweise mit zusätzlichen Stirnflächen in der Regel parallel zum gezeichneten Querschnitt. Diese weiteren zwei Seitenwände spannen die Rahmstruktur auf.

Die schwingfähige Membran ist bevorzugt flächig innerhalb des freibleibenden Fläche aufgehangen. Die flächige Ausbreitung der schwingfähigen Membran kennzeichnet eine horizontale Richtung, während die vertikalen Abschnitte im Wesentlichen orthogonal dazu vorliegen. In Bezug auf die Stirnflächen kann die Membran an diesen Seitenwänden angehaftet sein oder dort zwecks größerer Beweglichkeit geschlitzt sein. Vorteilhaft kann der Schlitz einen dynamischen Hochpass darstellen, welcher beispielsweise ein Frontvolumen und Rückvolumen miteinander koppelt.

In einer bevorzugten Ausführungsform der Erfindung wird der Träger aus einem Substrat gebildet, bevorzugt ausgewählt aus einer Gruppe umfassend monokristallines Silizium, Polysilizium, Siliziumdioxid, Siliziumcarbid, Siliziumgermanium, Siliziumnitrid, Nitrid, Germanium, Kohlenstoff, Galliumarsenid, Galliumnitrid, Indiumphosphid und/oder Glas.

Diese Materialien sind in der Halbleiter- und/oder Mikrosystemherstellung einfach und kostengünstig zu bearbeiten und eignen sich für eine Herstellung im großen Maßstab. Die Trägerstruktur kann aufgrund der Materialien und/oder Herstellungsweisen flexibel hergestellt werden. Insbesondere ist bevorzugt eine Herstellung des MEMS-Wandlers umfassend eine schwingfähige Membran zusammen mit einem Träger in einem (Halbleiter-)prozess, bevorzugt auf einem Wafer möglich. Hierdurch wird die Herstellung weiter vereinfacht und verbilligt, sodass kostengünstig ein kompakter und robuster MEMS-Wandler bereitgestellt werden kann.

Bevorzugt ist eine Positionierung der mindestens eine Elektrode endseitig vorgesehen, sodass eine Kontaktierung mit einer Elektronik, z. B. an eine Strom- oder Spannungsquelle im Falle eines MEMS-Lautsprechers, an einem Ende der schwingfähigen Membran erfolgen kann, bevorzugt an einem Ende, an welchem die Membran am Träger aufgehangen vorliegt. Elektrode meint bevorzugt einen Bereich aus einem leitfähigen Material (bevorzugt einem Metall), welcher für eine solche Kontaktierung mit einer Elektronik, z. B. einer Strom- und/oder Spannungsquelle im Falle eines MEMS-Lautsprechers, eingerichtet ist. Bevorzugt kann es sich um einen Elektrodenpad handeln. Besonders bevorzugt dient das Elektrodenpad der Kontaktierung mit einer Elektronik und ist selbst mit einer leitfähigen Metallschicht verbunden, welche sich über die gesamte Fläche der schwingfähigen Membran erstrecken kann. Teilweise wird im Folgenden die leitfähige Schicht zusammen mit einem Elektrodenpad als Elektrode, beispielsweise als Top-Elektrode oder Bottom-Elektrode bezeichnet.

Besonders bevorzugt liegt die Lage aus einem leitfähigem Material, bevorzugt Metall, im Sinne einer Top- oder Bottomelektrode als eine durchgängige bzw. ganzflächige oder zusammenhängende Schicht der schwingfähigen Membran vor, welche eine im Wesentlichen homogene Fläche bildet und insbesondere nicht strukturiert wird. Stattdessen werden bevorzugt mittels einer unstrukturierten Lage aus einem leitfähigem Material, bevorzugt Metall, die zwei oder mehr vertikalen Abschnitte mit der endseitigen Elektrode bzw. dem Elektrodenpad kontaktiert.

In bevorzugten Ausführungsformen umfasst der MEMS-Wandler zwei endseitige Elektroden. Bevorzugt kann die Kontaktierung mit einer Elektronik, z. B. einer Strom- oder Spannungsquelle, mit den Elektroden an gegenüberliegende Enden der schwingfähigen Membran erfolgen, zwischen welche die vertikalen Abschnitten vorliegen, sodass mittels der endseitigen Elektroden die Aktuatorlage(n) in den vertikalen Abschnitten angesteuert werden können.

Die endseitige Bereitstellung der Elektroden grenzt sich somit bevorzugt von einer Kontaktierung ab, welche die jeweiligen vertikalen Abschnitte mit jeweiligen separaten Elektroden ansteuert bzw. im Falle eines MEMS-Mikrofons erzeugte elektrische Signale abgreift. Bevorzugt umfasst der MEMS-Wandler somit genau ein oder genau zwei Elektroden zur endseitigen Kontaktierung und keine weiteren Elektroden(pads) für eine Kontaktierung mittiger vertikaler Abschnitte.

Bevorzugt dient die Lage aus einem Aktuatormaterial in den vertikalen Abschnitten als Bestandteil eines mechanischen Bimorphs, wobei durch Ansteuerung derAktuatorlage über die Elektrode eine laterale Wölbung der vertikalen Abschnitte bewirkt wird oder wobei durch eine induzierte laterale Wölbung ein entsprechendes elektrisches Signal erzeugt wird. Es hat sich als überaus hilfreich für die Performance des mechanischen Bimorphs erwiesen, dass Korrugationen und/oder Schwächungsbereiche an vertikalen, horizontalen und/oder an Verbindungsstellen zwischen vertikalen und horizontalen Bereichen vorliegen.

In einer bevorzugten Ausführungsform weisen die zwei oder mehr vertikalen Abschnitte mindestens zwei Lagen auf, wobei eine Lage ein Aktuatormaterial und eine zweite Lage ein mechanisches Stützmaterial umfasst und wobei mindestens die Lage umfassend das Aktuatormaterial und mit einer endseitigen Elektrode kontaktiert vorliegt, sodass die horizontalen Schwingungen durch eine Formänderung des Aktuatormaterials gegenüber dem mechanischen Stützmaterial erzeugbar sind. In der Ausführungsform wird der mechanische Bimorph durch eine Lage aus Aktuatormaterial (z. B. einem piezoelektrischen Material) und einer passiven Lage gebildet, welche als mechanische Stützschicht fungiert. Für die Biegung kann sowohl ein transversaler als auch longitudinaler Piezoeffekt genutzt werden.

Bei Ansteuerung derAktuatorlage kann diese beispielsweise eine transversale oder longitudinale Streckung oder Stauchung erfahren. Gegenüber der mechanischen Stützschicht wird hierdurch ein Stressgradient erzeugt, welcher zu einer lateralen Wölbung bzw. Schwingung führt. Durch wechselnde Polung an den Elektroden kann bevorzugt ein push-pull-Betrieb erfolgen, wodurch abwechselnd nahezu das gesamte Luftvolumen zwischen den vertikalen Abschnitten in vertikaler Emissionsrichtung bewegt werden kann. Die Korrugationen und/oder Schwächungsbereiche erlauben diesbezüglich eine besonderes hohe Auslenkbarkeit der vertikalen Abschnitte und steigern mithin das Verdrängungsvolumen.

Vorteilhaft an dem Aktuatorprinzip ist somit eine hoch effiziente Übersetzung der horizontalen Schwingungen vertikaler Abschnitte in eine vertikale Volumenbewegung bzw. Schallerzeugung. Mithilfe der Anbringung von Korrugationen und/oder Schwächungsbereichen kann dies vorteilhaft besonders optimiert erfolgen, da sowohl die Biegesteifigkeit der vertikalen Abschnitte als auch deren Rotationsfreiheit einstellbar ist.

Da das Aktuatorprinzip nicht auf einer elektrostatischen Anziehung basiert, sondern auf einer relativen Formänderung (z. B. Stauchung, Streckung und/oder Scherung) derAktuatorlage gegenüber einer Stützschicht, kann ein Verkleben der Membranabschnitte ausgeschlossen werden. Stattdessen können sich die vertikalen Abschnitte endlich berühren und sind somit in ihrer Auslenkung nicht eingeschränkt.

In einer weiteren bevorzugten Ausführungsform umfassen die zwei oder mehr vertikalen Abschnitte mindestens zwei Lagen, wobei beide Lagen ein Aktuatormaterial umfassen und mit Elektroden vorzugsweise endseitig kontaktiert vorliegen und die horizontalen Schwingungen durch eine Formänderung der einen Lage gegenüber der anderen Lage erzeugbar sind. In der Ausführungsform wird die horizontale Schwingung der vertikalen Abschnitte mithin nicht durch einen Stressgradienten zwischen einer aktiven Aktuatorlage und einer passiven Stützschicht generiert, sondern durch eine relative Formänderung zweier aktiver Aktuatorlagen.

Die Aktuatorlagen können hierbei aus demselben Aktuatormaterial bestehen und unterschiedlich angesteuert werden. Auch können die Aktuatorlagen aus unterschiedlichen Aktuatormaterialien bestehen, beispielsweise aus piezoelektrischen Materialien mit unterschiedlichem Deformationskoeffizienten.

Im Sinne der Erfindung wird die "Lage umfassend ein Aktuatormaterial" bevorzugt auch als Aktuatorlage bezeichnet. Ein Aktuatormaterial meint bevorzugt ein Material, welches unter Anlegung einer elektrischen Spannung eine Formänderung, beispielsweise eine Dehnung, Stauchung oder Scherung erfährt oder umgekehrt unter Formänderung eine elektrische Spannung erzeugt.

Bevorzugt sind Materialien mit elektrischen Dipolen, welche durch das Anlegen einer elektrischen Spannung eine Formänderung erfahren, wobei die Orientierung der Dipole und/oder des elektrischen Feldes die Vorzugsrichtung der Formänderungen bestimmen kann.

Bevorzugt kann das Aktuatormaterial ein piezoelektrisches Material, ein Polymer Piezoelectrical Material und/oder elektroaktive Polymere (EAP) sein.

Besonders bevorzugt ist das piezoelektrisch Material ausgewählt aus einer Gruppe umfassend Blei-Zirkonat-Titanat (PZT), Aluminiumnitrid (AIN), Aluminium-Scandium-Nitrid (AIScN) und Zinkoxid (ZnO).

Im Sinne der Erfindung wird die "Lage umfassend ein mechanische Stützmaterial" bevorzugt auch als Stützlage oder Stützschicht bezeichnet. Das mechanische Stützmaterial bzw. die Stützlage dient bevorzugt als passive Lage, welche einer Formänderung der Aktuatorlage widerstehen kann. Im Gegensatz zu einer Aktuatorlage ändert das mechanische Stützmaterial beim Anlegen einer elektrischen Spannung bevorzugt seine Form nicht. Bevorzugt ist das mechanische Stützmaterial elektrisch leitend, sodass es auch unmittelbar für eine Kontaktierung der Aktuatorlage verwandt werden kann. Es kann aber auch in einigen Ausführungsformen nichtleitend sein und beispielsweise mit einer elektrisch leitfähigen Lage beschichtet vorliegen.

Besonders bevorzugt handelt es sich bei dem mechanischen Stützmaterial um monokristallines Silizium, ein Polysilizium oder ein dotiertes Polysilizium.

Während die Aktuatorlage bei einer elektrischen Spannung eine Formänderung erfährt, verbleibt die Lage des mechanischen Stützmaterials im Wesentlichen unverändert. Der resultierende Stressgradient zwischen beiden Lagen (mechanischer Bimorph) bewirkt bevorzugt eine horizontale Wölbung. Zu diesem Zweck ist die Dicke der Stützlage im Vergleich zur Dicke der Aktuatorlage bevorzugt so zu wählen, dass für die Wölbung ein hinreichend großer Stressgradient generiert wird. Für dotiertes Polysilizium als mechanisches Stützmaterial und einem piezoelektrischen Material wie PZT oder AIN haben sich beispielsweise im Wesentlichen gleich große Dicken, bevorzugt zwischen 0,5 µm und 2 µm, als besonders geeignet erwiesen.

Begriffe wie im Wesentlichen, ungefähr, etwa, ca. etc. beschreiben bevorzugt einen Toleranzbereich von weniger als ±20%, bevorzugt weniger als ± 10 %, noch stärker bevorzugt weniger als ± 5% und insbesondere weniger als ± 1%. Angaben von im Wesentlichen, ungefähr, etwa, ca. etc. offenbaren und umfassen stets auch den exakten genannten Wert.

Eine Kontaktierung der Aktuatorlage und/oder der Lage aus einem mechanischen Stützmaterial und somit das Anlegen einer elektrischen Spannung kann über endseitige Elektroden unmittelbar erfolgen oder durch eine Lage aus einem leitfähigen Material unterstützt werden.

In einer bevorzugten Ausführungsform umfasst die schwingfähige Membran daher mindestens eine Lage aus einem leitfähigen Material.

In bevorzugten Ausführungsformen ist das leitfähige Material ausgewählt aus einer Gruppe umfassend Platin, Wolfram, (dotiertes) Zinnoxid, monokristallines Silizium, Polysilizium, Molybdän, Titan, Tantal, Titan-Wolfram Legierung, Metallsilizid, Aluminium, Graphit und/oder Kupfer.

Die erfindungsgemäße Einbringung von Korrugationen und/oder die Schwächungsbereichen kann sich gleichermaßen auf Lagen aus einem Aktuatormaterial, einem mechanische Stützmaterial und/oder einem leitfähigen Material beziehen.

In einer bevorzugten Ausführungsform ist der MEMS-Wandler dadurch gekennzeichnet, dass die eine oder mehreren Korrugationen und/oder Schwächungsbereiche entlang der horizontalen Abschnitte, entlang der vertikalen Abschnitten und/oder an Verbindungsstellen zwischen vertikalen Abschnitten und horizontalen Abschnitten vorliegen.

So kann es bevorzugt sein, die Korrugationen und/oder die Schwächungsbereiche lediglich entlang der horizontalen Abschnitte anzubringen sind. Ebenfalls kann es bevorzugt sein, Korrugationen und/oder Schwächungsbereiche nur entlang der vertikalen Abschnitten anzubringen. In weiteren bevorzugten Ausführungsformen sind Korrugationen und/oder Schwächungsbereiche an den vertikalen Abschnitten und den horizontalen Abschnitten angebracht. Weiterhin kann es bevorzugt sein, dass Korrugationen und/oder Schwächungsbereiche an Verbindungstellen alleine oder in Kombination mit weiteren Korrugationen und/oder Schwächungsbereichen an vertikalen und/oder horizontalen Abschnitten vorliegen.

Vorteilhafterweise führen Korrugationen und/oder Schwächungsbereiche an horizontalen Abschnitten sowie an Verbindungsstellen zu einer Steigerung der Rotationsfreiheit der vertikalen Abschnitte. Korrugationen und/oder Schwächungsbereiche an vertikalen Abschnitten senken vorteilhaft die Biegesteifigkeit, sodass die Auslenkbarkeit der vertikalen Abschnitte weiter gesteigert werden kann. Beide Positionierungen können alleine oder in Kombination zur Erzeugung hoher Schalldruckpegel genutzt werden, ohne dass nennenswerte Verzerrungen auftreten.

In einer weiteren bevorzugten Ausführungsform ist der MEMS-Wandler dadurch gekennzeichnet, dass entlang eines vertikalen Abschnitts und/oder eines horizontalen Abschnitts mindestens 1, 2, 3, 4, 5 oder mehr Korrugationen und/oder Schwächungsbereiche angebracht sind.

Vorteilhaft stellt die Anzahl der Korrugationen und/oder Schwächungsbereiche einen Parameter dar, durch dessen Auswahl das Schwingungsverhalten der vertikalen Abschnitte optimiert werden kann. Durch eine höhere Anzahl an Korrugationen und/oder Schwächungsbereichen an vertikalen Abschnitten und/oder Verbindungsstellen wird vorteilhaft eine höhere Rotationsfreiheit erlangt. Durch eine höhere Anzahl an Korrugationen und/oder an Schwächungsbereichen an den vertikalen Abschnitten wird vorteilhaft eine höhere Auslenkbarkeit der vertikalen Abschnitte durch eine stärkere Verringerung der Steifigkeit der vertikalen Abschnitte erlangt.

In weiteren Anwendungszwecken kann es bevorzugt sein, eine verhältnismäßige geringe Anzahl an Korrugationen und/oder Schwächungsbereichen bereitzustellen, beispielsweise lediglich eine oder zwei Korrugationen und/oder Schwächungsbereiche pro vertikalem und/oder horizontalem Abschnitt. Mithin kann vorteilhafterweise auf besonders einfache Weise das Schwingungsverhalten der schwingfähigen Membran durch eine entsprechende Auswahl, insbesondere hinsichtlich der Anzahl der Korrugationen und/oder der Schwächungsbereiche, das Schwingungsverhalten der schwingfähigen Membran optimiert werden.

In einer weiteren bevorzugten Ausführungsform ist der MEMS-Wandler dadurch gekennzeichnet, dass die eine oder mehreren Korrugationen einen rechteckigen, trapezförmigen, quadratischen, dreieckigen, teilkreisförmigen und/oder runden Querschnitt aufweisen.

Die genannten geometrischen Formen können vorteilhaft die Optimierung des Schwingungsverhalten durch die Korrugationen begünstigen. Zudem hat sich die Herstellung dieser geometrischen Ausgestaltungen der Korrugationen vorteilhaft als besonders einfach erwiesen. Die bevorzugten Querschnitte der Korrugationen können beispielsweise durch eine Bereitstellung einer entsprechend geformten Formgebungskomponente bzw. eines strukturierten Trägersubstrats und eines anschließenden Beschichtungsverfahrens ermöglicht werden.

Vorzugsweise weisen eine oder mehrere Korrugationen einen rechteckigen Querschnitt auf. Ein rechteckiger Querschnitt zeichnet sich bevorzugt durch ein ebenes Viereck aus, dessen Innenwinkel alle im Wesentlichen rechte Winkel sind. Ebenfalls kann es bevorzugt sein, dass eine oder mehrere Korrugationen einen trapezförmigen Querschnitt aufweisen. Ein trapezförmiger Querschnitt zeichnet sich bevorzugt durch ein ebenes Viereck mit zwei im Wesentlichen parallel zueinander liegenden Seiten aus. Weiterhin kann es bevorzugt sein, dass eine oder mehrere Korrugationen einen quadratischen Querschnitt aufweisen. Ein quadratischer Querschnitt zeichnet sich bevorzugt durch vier im Wesentlichen gleich lange Seiten und vier im Wesentlichen rechte Winkel aus. Zudem kann es bevorzugt sein, dass eine oder mehrere Korrugationen einen dreieckigen Querschnitt aufweisen. Ein dreieckiger Querschnitt zeichnet sich bevorzugt durch drei Winkel aus, die durch ihre Seiten aufgespannt werden.

Ebenfalls kann es bevorzugt sein, dass eine oder mehrere Korrugationen einen teilkreisförmigen Querschnitt aufweisen. Hierbei ist mit "teilkreisförmig" bevorzugt ein Teilausschnitt einer Kreisform gemeint. Ein teilkreisförmiger Querschnitt kann bevorzugt auch in Form eines im Wesentlichen Halbkreises vorliegen. Darüber hinaus kann es bevorzugt sein, dass ein runder Querschnitt einer oder mehrerer Korrugationen vorliegt. Ein runder Querschnitt meint bevorzugt einen Querschnitt, welcher auf Ecken und/oder Kanten innerhalb der Korrugationen verzichtet und beispielsweise halbkreisförmig oder auch eine andere Form (elliptisch etc.) aufweisen kann.

In einer bevorzugten Ausführungsform ist der MEMS-Wandler dadurch gekennzeichnet, dass die eine oder mehreren Korrugationen eine Tiefe von 1 µm - 100 µm bevorzugt 2 µm - 20 µm und/oder eine Breite zwischen ca. 0,5 µm - 50 µm, bevorzugt zwischen 1 µm - 5 µm, aufweisen.

In einer weiteren bevorzugten Ausführungsform ist der MEMS-Wandler dadurch gekennzeichnet, dass die eine oder mehreren Korrugationen ein Aspektverhältnis von Breite zu Tiefe von 1:1 oder mehr, bevorzugt von 1:2 oder mehr aufweist. Als Aspektverhältnis wird bevorzugt das Verhältnis aus der Tiefe bzw. Höhe zur (kleinsten) lateralen Ausdehnung bezeichnet.

Die genannten Aspektverhältnisse sind dahingehend vorteilhaft, dass dies zu einer besonders effektiven Erhöhung der Auslenkbarkeit der vertikalen Abschnitte führen und zudem einfach und zuverlässig durch im Stand der Technik bekannten Methoden herstellen lassen.

In einer bevorzugten Ausführungsform ist der MEMS-Wandler dadurch gekennzeichnet, dass die horizontalen Abschnitte und/oder vertikalen Abschnitte mehrlagig ausgebildet sind und wobei eine oder mehrere Schwächungsbereiche durch eine Variation der Schichtdicke mindestens einer Lage bewirkt wird, wobei bevorzugt die Schichtdicke der mindestens einen Lage auf weniger als 70%, vorzugweise weniger als 60%, 50%, 40% oder weniger einer Ausgangsschichtdicke reduziert ist.

Wie obig beschrieben, meint ein Schwächungsbereich bevorzugt eine im Vergleich zur durchschnittlichen Dicke des Teilabschnittes der Membran reduzierte Schichtdicke einer Lage der Membran. Im Falle einer mehrlagigen Membran kann die Variation der Schichtdicken im Schwächungsbereich eine Reduktion der Schichtdicke einer Auswahl der Lagen, beispielsweise einer oder zweier Lagen oder aber sämtlicher Lagen der mehrlagigen Membran betreffen. Hierbei weisen Schwächungsbereiche ähnliche vorteilhafte technischen Effekte auf wie die Anbringung von Korrugationen.

Die genannten Reduzierungen der Schichtdicken haben sich dahingehend als vorteilhaft erwiesen, dass sie einerseits besonders einfach und schnell bereitzustellen sind und ebenso eine besonders effiziente Optimierung des Schwingungsverhaltens der schwingfähigen Membran ermöglichten.

In einer weiteren bevorzugten Ausführungsform ist der MEMS-Wandler dadurch gekennzeichnet, dass die horizontalen Abschnitte und/oder vertikalen Abschnitte mehrlagig ausgebildet sind und wobei eine oder mehrere Schwächungsbereiche durch eine bereichsweise Reduzierung einer Schichtdicke mindestens einer Lage auf 0 % gebildet sind. Vorzugsweise kann diese eine Lage umfassend ein leitfähiges Material, eine Lage umfassend ein Stützmaterial und/oder die Aktuatorlage betreffen.

Eine Reduzierung auf 0 % der Ausgangsschichtdicke bezeichnet bevorzugt das vollständige Fehlen einer Lage an zumindest einem Teilbereich der Membran, welcher mithin den Schwächungsbereich definiert, sodass im erfindungsgemäßen Kontext dies auch synonym als ein Fehlen oder einerAussparung einer Lage im betreffenden (Schwächungs-)bereich bezeichnet werden kann.

Mit einem Schwächungsbereich, der sich durch ein bereichsweises Fehlen einer Lage auszeichnet, kann beispielsweise eine verringerte Aktuierung bewirkt werden.

Beispielsweise kann an einem leitfähigen Material der Membran - beispielsweise eine Top- und/oder Bottom-Elektrode - eine Aussparung vorliegen.

Bevorzugt kann in einem oder mehreren Schwächungsbereichen ein Top-Elektrode ausgespart werden, beispielsweise in einem horizontalen Abschnitt. In dem Bereich, in dem die Top-Elektrode fehlt, kann im Gegensatz zum übrigen horizontalen Abschnitt der Membran kein oder nur ein verringertes elektrisches Feld zwischen der Top- und Bottom-Elektrode ausgebildet werden. Eine piezoelektrische Aktuatorlage, welche sich zwischen der Top- und Bottom-Elektrode befindet, wird mithin im Bereich der Aussparung der Top-Elektrode nicht oder in geringerem Maße zu einer Formänderungen angeregt bzw. aktuiert. Auf analoge Weise kann es bevorzugt sein, dass eine oder mehrere Schwächungsbereiche durch ein bereichsweises Aussparen einer Bottom-Elektrode gebildet werden.

Die verringerte bzw. schwächere Aktuierung basiert - ohne auf die Theorie beschränkt zu sein - auf einem abgeschwächten elektrischen Feld. Die verringerte Aktuierung resultiert mithin durch bevorzugt ein Verringern oder Beseitigen eines piezoelektrischen Effektes an der betreffenden Stelle. Hierdurch kann vorteilhaft das Schwingungsverhalten der Membran optimiert werden, indem eine Beweglichkeit angrenzender vertikaler Abschnitte erhöht und/oder unerwünschte Effekte wie ein Buckling vermieden werden.

Eine derartige bereichsweise Reduzierung einer Aktuierbarkeit der Membran kann ebenso durch ein bereichsweises Fehlen der Aktuatorlage - beispielsweise einer piezoelektrischen Aktuatorlage - bewirkt werden.

Ebenso kann es bevorzugt sein, dass die Aktuatorlage beispielsweise im Abschnitt des Schwächungsbereiches durch ein Material ersetzt wird, welches kein Aktuatormaterial ist, beispielsweise durch ein dielektrisches Material. Vorteilhaft kann durch einen bereichsweisen Austausch einer funktionalen Lage (z. B. einer Aktuatorlage) gegen eine nicht funktionelle Schicht (beispielsweise einem dielektrischen Material als Isolationsmaterial) der Effekt einer reduzierten Aktuierung bei einer gleichzeitig homogenen Gesamtschichtdicke im Schwächungsbereich erhalten werden.

Weiterhin kann es auch bevorzugt sein, in einem Schwächungsbereich zusätzlich ein Isolationsmaterial als Isolationsschicht (z. B. ein dielektrisches Material) einzubringen - beispielsweise zwischen einer Lage umfassend ein leitfähiges Material (Top- und/oder Bottom-Elektrode) - und der Aktuatorlage. Auch hierdurch wird der piezoelektrische Effekt und mithin die Aktuierbarkeit des mehrlagigen Membran im Schwächungsbereich reduziert. In diesem Fall kann es sich vorzugsweise um einen Schwächungsbereich durch eine Variation der Schichtdicke mindestens einer Lage handeln, bei der eine Lage zusätzlich eingebracht wird und sich ggf. die Gesamtdicke der Membran sogar erhöht.

In weiteren bevorzugten Ausführungsformen kann auch ein Schwächungsbereich durch das bereichsweise Fehlen bzw. Aussparen einer mechanischen Stützlage gekennzeichnet sein. Hierdurch wird die Steifigkeit des betreffenden Teilbereiches reduziert, sodass ebenfalls eine Optimierung der Auslenkbarkeit der Membran erreicht werden kann. Es versteht sich, dass ebenfalls im Falle der mechanischen Stützlage das ausgesparte Stützmaterial auch durch ein Material mit geringerer mechanischer Steifigkeit (bzw. einem höheren Elastizitätsmodul) ersetzt werden kann.

Die Aussparung einer oder mehrerer Lagen kann während der Beschichtung durch eine vorgegebene Maskierung gebildet werden. Ebenfalls kann es bevorzugt sein, die Aussparung nach der Beschichtung durch eine Strukturierung bereitzustellen.

In bevorzugten Ausführungsformen liegt ein Schwächungsbereich, der durch das Fehlen mindestens einer Lage gekennzeichnet ist, an einem horizontalen Abschnitt vor. Es kann auch bevorzugt sein, dass sich ein derartiger Schwächungsbereich innerhalb einer Korrugation befindet. D. h. das beispielsweise in einer Korrugation, welche als eine Vertiefung oder Erhebung in einem ansonsten im Wesentlichen planplanaren Verlauf des Teilabschnitts gekennzeichnet ist, mindestens eine Lage (z. B. eine Stützlage, Aktuatorlage, Top- und/oder Bottom-Elektrode) ausgespart wird.

In besonders bevorzugten Ausführungsformen ist der MEMS-Wandler dadurch gekennzeichnet, dass die horizontalen Abschnitte und/oder vertikalen Abschnitte mehrlagig ausgebildet sind und wobei eine oder mehrere Schwächungsbereiche durch eine Variation der Schichtdicke mindestens einer Lage (vorzugweise genau einer Lage) bewirkt wird, wobei bevorzugt die Schichtdicke der mindestens einen Lage auf weniger als 70 %, vorzugweise weniger als 60 %, 50 %, 40 % oder auf 0 % einer Ausgangsschichtdicke reduziert ist, wobei jedoch die Schichtdicke mindestens einer Lage der Membran (vorzugsweise sämtlicher Lagen bis auf eine Lage) nicht reduziert wird. Hierdurch werden gezielt die mechanischen oder funktionellen Eigenschaften der Membran im Schwächungsbereich verändert, ohne die Integrität der Membran zu beeinträchtigen. Etwaige akustische Nachteile durch die Bereitstellung durchgehender Öffnungen können mithin vermieden werden.

In einigen Ausführungsformen können die Schwächungsbereiche jedoch auch als durchgehende Öffnungen bereitgestellt werden, wobei mithin bereichsweise die Schichtdicke sämtlicher Lagen auf 0 % reduziert werden. Auch durch die Bereitstellung durchgehender Öffnungen kann die mechanische Steifigkeit der horizontalen Abschnitte und/oder vertikalen Abschnitte verringert werden und mithin ein verbessertes Schwingungsverhalten der Membran resultieren.

Dies kann insbesondere durch die geometrische Form der Öffnungen und/oder der Anzahl der Öffnungen optimiert werden. In bevorzugten Ausführungsformen liegen 1, 2, 3, 4, 5, 6, 7, 8, 9, 10, 15, 10, 30, 50, 100 oder mehr Öffnungen an einem horizontalen und/oder vertikalen Abschnitt vor. Umso mehr Öffnungen vorliegen, desto stärker kann der mechanische Widerstand während einer Schwingung verringert werden. Die Öffnungen können bevorzugt kreisförmig, ellipsenförmig, eckig oder als Schlitz aufgebracht vorliegen. In einer weiteren bevorzugten Ausführungsform ist der MEMS-Wandler dadurch gekennzeichnet, dass durch eine Ausgestaltung der einen oder mehrere Korrugationen und/oder Schwächungsbereiche, bevorzugt hinsichtlich einer Tiefe, Breite, Schichtdicke, Geometrie und/oder Anzahl, eine Steifigkeit der horizontalen Abschnitte und/oder vertikalen Abschnitte einstellbar ist, um ein Schwingungsverhalten der vertikalen Abschnitte zu optimieren.

Vorteilhafterweise kann damit durch eine Ausgestaltung und/oder Wahl von Parametern umfassend Tiefe, Breite, Schichtdicke, Geometrie und/oder Anzahl eine Steifigkeit der vertikalen Abschnitte optimiert werden, insbesondere je nach Anwendungszweck des MEMS-Wandlers angepasst werden. Insbesondere umfasst die Steifigkeit der vertikalen Abschnitte die Biegesteifigkeit, d. h. den Widerstand gegen eine Biegung während einer horizontalen Schwingung, beispielsweise zur Erzeugung oder bei der Aufnahme von Druckwellen. Durch die Verringerung der Biegesteifigkeit ist vorteilhaft eine höhere maximale Auslenkbarkeit der vertikalen Abschnitte gegeben, sodass vorteilhafterweise auch höhere Schalldruckpegel mit guter Klangqualität durch einen bevorzugten MEMS-Lautsprecher erzeugt werden können. In Bezug auf eine bevorzugte Bereitstellung des MEMS-Wandlers als MEMS-Mikrofon kann vorteilhaft dessen Sensitivität, Aufnahmequalität und/oder Signal-zu-Rausch Verhältnis verbessert werden.

In einer bevorzugten Ausführungsform ist der MEMS-Wandler dadurch gekennzeichnet, dass die Einbringung von einer oder mehreren Korrugationen und/oder Schwächungsbereichen an den horizontalen Abschnitten und/oder vertikalen Abschnitten eine Rotationsfreiheit der vertikalen Abschnitte erhöht, um ein Schwingungsverhalten der vertikalen Abschnitte zu optimieren.

Vorteilhaft kann durch eine Erhöhung der Rotationsfreiheit die Beweglichkeit ausgehend vom Verbindungspunkt der vertikalen Abschnitte an den horizontalen Abschnitten gesteigert werden. Die Erhöhung der Rotationsfreiheit kann damit bevorzugt als eine verbesserte Beweglichkeit an dem Aufhängepunkt am horizontalen Abschnitt aufgefasst werden.

In einer bevorzugten Ausführungsform ist die schwingfähige Membran als Mäanderstruktur ausgebildet, wobei die Mäanderstruktur durch die vertikalen Abschnitte und horizontalen Abschnitte gebildet wird.

Eine Mäanderstruktur bezeichnet bevorzugt eine aus einer Abfolge zueinander im Wesentlichen orthogonaler Abschnitte im Querschnitt gebildete Struktur. Bei den zueinander orthogonalen Abschnitten handelt es sich bevorzugt um vertikale und horizontale Abschnitte der schwingfähigen Membran. Besonders bevorzugt ist die Mäanderstruktur im Querschnitt rechteckig. Es kann aber auch bevorzugt sein, dass die Mäanderstruktur im Querschnitt eine Sägezahnform (Zick-Zack-Form) aufweist oder kurvenförmig bzw. wellenförmig ausgestaltet ist. Dies ist insbesondere der Fall, sofern die vertikalen Abschnitte nicht exakt parallel mit der vertikalen Emissions- oder Detektionsrichtung ausgerichtet vorliegen, sondern einen Winkel beispielsweise von ± 30°, bevorzugt ± 20°, besonders bevorzugt ± 10° mit der vertikalen Richtung einschließen. Bevorzugt umfasst die Mäanderstruktur strukturelle und/oder funktionelle Unregelmäßigkeiten bzw. Inhomogenitäten in Form von Korrugationen und/oder Schwächungsbereichen.

Die horizontalen Abschnitte können in bevorzugten Ausführungsformen ebenfalls nicht exakt unter einem orthogonalen Winkel von 90° zur vertikalen Emissions- oder Detektionsrichtung stehen, sondern beispielsweise einen Winkel zwischen 60° und 120°, bevorzugt zwischen 70° und 110°, besonders bevorzugt zwischen 80° und 100° mit der vertikalen Richtung einschließen.

Im Falle einer kurvenförmigen Form der vertikalen und/oder horizontalen Abschnitte der schwingfähigen Membran im Querschnitt bezieht sich die Ausrichtung bevorzugt auf eine Tangente an die vertikalen und/oder horizontalen Abschnitte an deren jeweiligen Mittelpunkten.

Die erfindungsgemäßen Korrugation definieren auch in diesem Fall bevorzugt eine lokale Abweichung (Vertiefung oder Erhebung) von einem ansonsten kontinuierlichen Verlauf der (kurvigen) vertikalen und/oder horizontalen Abschnitte.

Die Mäanderstruktur entspricht somit bevorzugt einer entlang der Breite gefalteten Membran. Im Sinne der Erfindung kann eine schwingfähige Membran daher bevorzugt auch als Faltenbalg bezeichnet werden. Die parallelen Falten des Faltenbalges bilden bevorzugt die vertikalen Abschnitte. Die Verbindungsabschnitte zwischen den Falten bilden bevorzugt die horizontalen Abschnitte. Bevorzugt sind die vertikalen Abschnitte länger als die horizontalen Abschnitte, beispielsweise um einen Faktor 1,5, 2, 3, 4 oder mehr.

In Bezug auf die Funktion einer schwingfähigen Membran in Mäanderform zur Erzeugung oder Aufnahme von Schallwellen sind die vertikalen Abschnitte maßgeblich, welche auch als Lamellen bezeichnet werden können. Bevorzugt sind die vertikalen Abschnitte mehrlagig aufgebaut und bilden einen mechanischem Bimorph. Beispielsweise können die vertikalen Abschnitte jeweils eine Aktuatorlage sowie eine passive Lage aus einem Stützmaterial und/oder zwei verschieden steuerbaren Aktuatorlagen umfassen. Die horizontalen Abschnitte der gefalteten Membran können bevorzugt identisch zu den vertikalen Abschnitten aufgebaut sein. Es kann aber ebenso bevorzugt sein, dass die horizontalen Abschnitte - im Gegensatz zu den vertikalen Abschnitten - keine Aktuatorlage aufweisen, sondern lediglich eine mechanische Stützschicht und/oder eine elektrisch leitfähige Schicht.

In einer bevorzugten Ausführungsform ist die mindestens eine Lage aus einem Aktuatormaterial der schwingfähigen Membran eine durchgängige Lage. Durchgängig meint bevorzugt, dass im Querschnittsprofil keine Unterbrechungen vorliegen. Demgemäß ist es in der genannten Ausführungsform bevorzugt, dass sowohl eine durchgängige Lage von Aktuatormaterial in den vertikalen als auch in den horizontalen Abschnitten vorliegt. Vorteilhaft ist mithin keine Strukturierung notwendig. Eine durchgängige Lage ist besonders einfach in der Herstellung und gewährleistet eine synchrone Aktuierung beim Betrieb eines MEMS-Lautsprechers. Im Hinblick auf eine Ausbildung von Schwächungsbereichen kann es jedoch auch bevorzugt sein, gezielt Unterbrechungen bzw. Aussparungen einer Aktuatorlage einzubringen, um das Schwingungsverhalten zu optimieren.

Die Performance des MEMS-Wandlers, insbesondere eines MEMS-Lautsprechers oder MEMS-Mikrofons, kann wesentlich von der Anzahl und/oder Dimensionierung der vertikalen Abschnitte bestimmt werden, wobei insbesondere Korrugationen und/oder Schwächungsbereiche, wie obig erläutert, zu einer besonders definierten Wölbung und Auslenkbarkeit der vertikalen Bereiche führen.

In bevorzugten Ausführungsformen umfasst die schwingfähige Membran mehr als 3, 4, 5, 10, 15, 20, 30, 40, 50, 100 oder mehr vertikale Abschnitte.

In bevorzugten Ausführungsformen umfasst die schwingfähige Membran weniger als 10 000, 5 000, 2 000 oder 1 000 oder weniger vertikale Abschnitte.

Die bevorzugte Anzahl von vertikalen Abschnitten führt zu einer hohen Schallleistung auf kleinsten Chip-Oberflächen, wobei insbesondere durch die Bereitstellung der Korrugationen und/oder Schwächungsbereiche ein ausgezeichnetes Klangbild und hervorragende Audioqualität erreicht wird.

Bevorzugt sind die vertikalen und/oder horizontalen Abschnitte im Wesentlichen flächig, das bedeutet insbesondere, dass ihre Ausdehnung in jeder der zwei Dimensionen (Höhe, Breite) ihrer Fläche größer ist als in einer hierzu senkrechten Dimension (der Dicke). Beispielsweise können Größenverhältnisse von mindestens 2:1, bevorzugt mindestens 5: 1, 10: 1 oder mehr bevorzugt sein. Korrugationen und/oder Schwächungsbereiche definieren, wie obig erläutert, vorzugsweise Abweichungen aus einer flächigen Ebene.

Im Sinne der Erfindung entspricht die Höhe der vertikalen Abschnitte bevorzugt der Dimension entlang der Richtung der Schallemission oder Schalldetektion. In Bezug auf die horizontalen Abschnitte bezeichnet hingegen eine Breite bevorzugt die Dimension entlang der Verbindungslinie zwischen zwei vertikalen Abschnitten.

Eine Dicke der vertikalen und/oder horizontalen Abschnitte entspricht bevorzugt einer Summe der Schichtdicke der einen oder mehreren Lagen, welche die vertikalen und/oder horizontalen Abschnitte bilden. Die Länge der vertikalen und/oder horizontalen Abschnitte entspricht bevorzugt einer zur Höhe bzw. Breite sowie zur Dicke orthogonalen Dimension. In den Querschnittsansichten der unten aufgeführten Abbildungen sind Höhe bzw. Breite und Dicke schematisch (nicht zwangsläufig skalengetreu) dargestellt, während die Dimension der Länge einer (nicht sichtbaren) Zeichnungstiefe der Abbildungen entspricht.

In einer bevorzugten Ausführungsform beträgt eine Höhe der vertikalen Abschnitte zwischen 10 µm und 1 000 µm, bevorzugt zwischen 50 µm und 500 µm, während eine Breite der horizontalen Abschnitte zwischen 2 µm und 200 µm, bevorzugt zwischen 5 µm und 100 µm beträgt.

In einer bevorzugten Ausführungsform beträgt eine Dicke der vertikalen und/oder horizontalen Abschnitte zwischen 100 nm und 10 µm, bevorzugt zwischen 500 nm und 5 µm und/oder eine Länge der vertikalen und/oder horizontalen Abschnitte zwischen 10 µm und 10 mm, bevorzugt zwischen 100 µm und 1 mm.

Die Korrugationen bzw. Schwächungsbereiche weisen in bevorzugten Ausführungsformen einen konstanten Querschnitt bzw. Schichtdickenvariation in der Dimension der Länge auf und können daher auch als Rillen bzw. Stege bezeichnet werden.

Im Falle der Aussparung in Lagen aus einem leitfähigem Material, also vorzugsweise der Top- und/oder Bottom-Elektrode, ist es bevorzugt, dass die Schwächungsbereiche keine durchgängigen Unterbrechungen in der Dimension der Länge der flächigen Membran darstellen. Stattdessen kann es beispielsweise bevorzugt sein, Leiterbahnen oder verbleibende leitende Bereiche vorzusehen, welche eine endseitige Kontaktierung und durchgängigen Stromfluss in der Top- und/oder Bottom-Elektrode gewährleisten. So kann die Aussparung der Top- und/oder Bottom-Elektrode vorzugsweise im Wesentlichen entlang der gesamten Dimension der Länge der Membran vorliegen, wobei die Aussparung durch dünne (z.B. weniger als 20 µm, vorzugsweise weniger als 10 µm) leitende Bereiche oder Leiterbahnen unterbrochen werden.

Mit den vorgenannten bevorzugten Dimensionierungen der schwingfähigen Membran bzw. der vertikalen Abschnitte kann ein besonders kompakter MEMS-Wandler, insbesondere MEMS-Lautsprecher oder MEMS-Mikrofon, bereitgestellt werden, welcher gleichzeitig eine hohe Leistungsfähigkeit mit ausgezeichnetem Klangbild oder Audioqualität verbindet.

In einem weiteren Aspekt betrifft die Erfindung ein Herstellungsverfahren für einen MEMS-Wandler, bevorzugt einem MEMS-Lautsprecher oder MEMS-Mikrofon, umfassend die folgenden Schritte:
- Ätzen eines Substrats, vorzugsweise von einer Vorderseite, zur Ausbildung einer Strukturierung, vorzugsweise einer Mäanderstruktur, sowie zur vorzugsweisen Ausbildung von Korrugationen,
- optionales Auftragen eines Ätzstops,
- Aufbringen mindestens zweier Lagen, wobei mindestens eine erste Lage ein Aktuatormaterial und eine zweite Lage ein mechanischen Stützmaterial umfassen oder mindestens zwei Lagen ein Aktuatormaterial umfassen, wobei vorzugsweise im Prozess der Aufbringung der mindestens zweier Lagen oder durch ein nachträgliches Ätzen einer oder mehrere Schwächungsbereiche bereitgestellt werden.
- Kontaktieren der ersten und/oder zweiten Lage mit einer Elektrode,
- Ätzen des Substrates, vorzugsweise von der Rückseite, und optionale Entfernung des Ätzstops, sodass die schwingfähige Membran zur Ausführung von Schwingungen an dem Träger befestigt wird, wobei die schwingfähige Membran vertikale Abschnitte und horizontale Abschnitte aufweist, wobei die vertikalen Abschnitte im Wesentlichen parallel zur vertikalen Richtung ausgebildet sind und die horizontalen Abschnitte die vertikalen Abschnitte miteinander verbinden, wobei die vertikalen Abschnitte und/oder die horizontalen Abschnitte eine oder mehrere Korrugationen und/oder Schwächungsbereiche aufweisen,
sodass durch Ansteuerung der Elektrode die vertikalen Abschnitte zu horizontalen Schwingungen angeregt oder bei Anregung der vertikalen Abschnitte zu horizontalen Schwingungen an der Elektrode ein elektrisches Signal erzeugt werden kann.

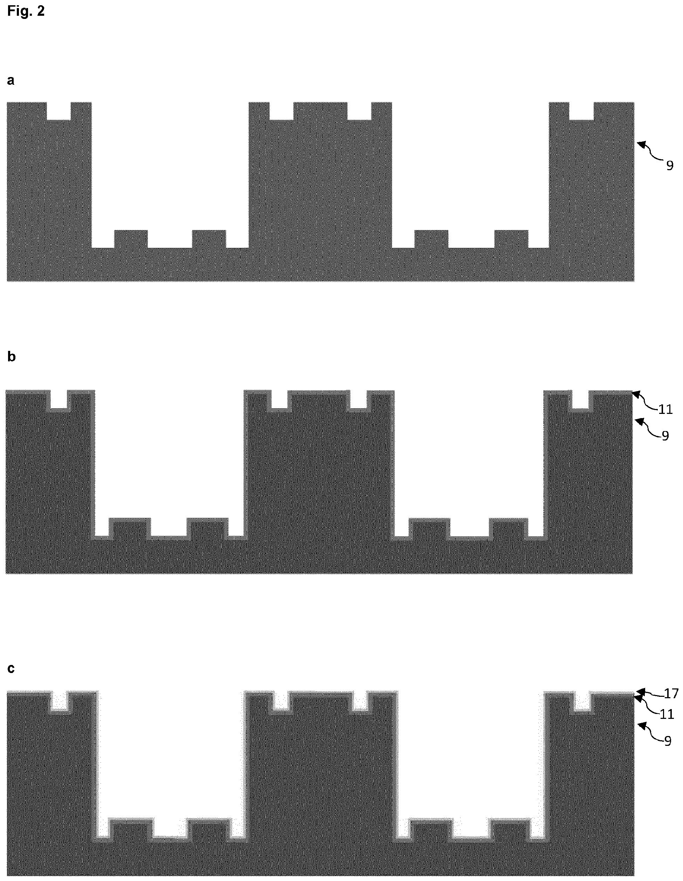

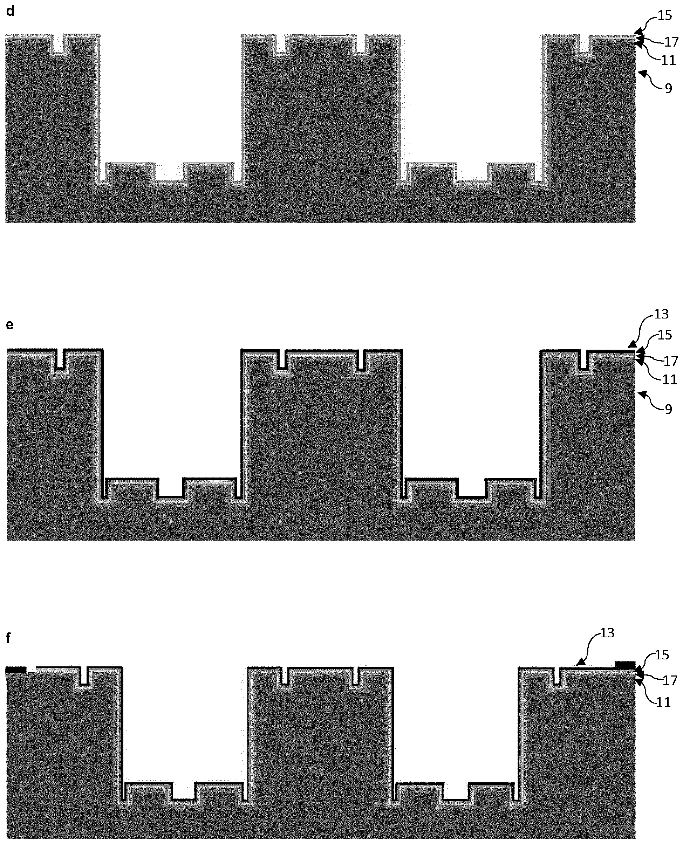

Der durchschnittliche Fachmann erkennt, dass technische Merkmale, Definitionen und Vorteile bevorzugter Ausführungsformen des beschriebenen MEMS-Wandlers, bevorzugt MEMS-Lautsprechers oder MEMS-Mikrofons, auch für das beschriebene Herstellungsverfahren gelten und umgekehrt. Vorzugsweise dient das beschriebene Herstellungsverfahren der Bereitstellung eines MEMS-Wandlers mit einer gefalteten schwingfähigen Membran mit einer Mäanderstruktur. Beispiele bevorzugter Herstellungsschritte werden in der Fig. 2 a-h gezeigt.

Bevorzugt umfasst das Ätzen des Substrats die Anbringung einer Struktur, die kongruent zur Mäanderstruktur für die Membran ist, um vertikale und horizontale Abschnitte sowie Korrugationen und/oder Schwächungsbereiche nach einer Beschichtung bereitzustellen. Alternativ können Korrugationen und/oder Schwächungsbereiche durch eine Strukturierung oder eine Beschichtung durch den Einsatz einer Maskierung hergestellt werden. Ebenso kann es bevorzugt sein Schwächungsbereiche, beispielsweise in Form von Aussparungen mindestens einer Lage, durch ein nachträgliche Strukturierung (Ätzen) der Membran bereitzustellen.

Als Substrat kann z. B. eines der bevorzugten, vorstehend genannten Materialien verwendet werden. Beim Ätzen kann ein Rohling, beispielsweise ein Wafer, in die gewünschte Grundform der Mäanderstruktur gebracht werden. In einem nächsten Schritt werden bevorzugt die Lagen für die schwingfähige Membran aufgebracht.

Ein Aufbringen der mindestens einer Lage eines leitfähigen Materials umfasst bevorzugt neben dem Aufbringen einer Lage ebenso das Aufbringen mehrerer Lagen und insbesondere eines Lagensystems. Ein Lagensystem umfasst dabei mindestens zwei planvoll zueinander aufgebrachte Lagen. Das Aufbringen einer Lage oder eines Lagensystems dient bevorzugt der Definition der schwingfähigen Membran umfassend vertikale Abschnitte, welche zu horizontalen Schwingungen angeregt werden können.

Bevorzugt kann das Aufbringen ausgesucht sein aus der Gruppe umfassend physikalische Gasphasenabscheidung (PVD), insbesondere thermisches Verdampfen, Laserstrahlverdampfen, Lichtbogenverdampfen, Molekularstrahlepitaxie, Sputtern, chemische Gasphasenabscheidung (CVD) und/oder Atomlagenabscheidung (ALD).

Ein Ätzen und/oder eine Strukturierung kann bevorzugt ausgesucht sein aus der Gruppe umfassend Trockenätzen, nasschemisches Ätzen und/oder Plasmaätzen, insbesondere Reaktives lonenätzen, Reaktives lonentiefenätzen (Bosch-Prozess).

Sollte eine weitere Strukturierung der schwingfähigen Membran - beispielsweise zur Ausbildung von Schwächungsbereichen wie beschrieben - gewünscht sein, kann diese z. B. durch weitere Ätzprozesse vorgenommen werden. Ebenso kann zusätzliches Material abgeschieden werden oder eine Dotierung durch übliche Verfahren vorgenommen werden.

Zur Kontaktierung der Lagen kann zusätzlich geeignetes Material, wie z. B. Kupfer, Gold und/oder Platin durch gängige Prozesse abgeschieden werden. Hierfür können bevorzugt physikalische Gasphasenabscheidung (PVD), chemische Gasphasenabscheidung (CVD) oder elektrochemische Abscheidung zum Einsatz kommen.

Mittels der Prozessschritte kann eine fein strukturierte schwingfähige Membran mit einer gewünschten Definition von vertikalen und horizontalen Abschnitten bereitgestellt werden, welche bevorzugt zwischen zwei Seitenbereich eines stabilen Trägers aufgehangen sind und Abmessungen im Mikrometerbereich aufweist. Die Herstellungsschritte gehören zu Standardverfahrensschritten der Halbleiterprozessierung, sodass diese sich bewährt haben und zudem für eine Massenherstellung geeignet sind.

Die Erfindung soll im Folgenden unter Verweis auf weitere Figuren und Beispiele erläutert werden. Die Figuren und Beispiele dienen der Illustration bevorzugter Ausführungsformen der Erfindung, ohne diese zu beschränken.

### FIGUREN

### Kurzbeschreibunq der Figuren

- **Fig. 1**: Schematische Darstellung von Korrugationen an vertikalen und horizontalen Abschnitten
- **Fig. 2**: Schematische Darstellung von bevorzugten Verfahrensschritten zur Herstellung eines MEMS-Wandlers
- **Fig. 3**: Schematische Darstellung von Korrugationen an vertikalen und horizontalen Abschnitten
- **Fig. 4**: Weitere schematische Darstellung von Korrugationen an vertikalen Abschnitten
- **Fig. 5**: Schematische Darstellung von Schwächungsbereichen an horizontalen Abschnitten
- **Fig. 6**: Simulationsergebnisse für das Schwingungsverhalten eines vertikalen Abschnittes im Falle der Einbringung von Korrugationen in angrenzenden horizontalen Abschnitten
- **Fig. 7**: Schematische Darstellung von Schwächungsbereichen durch Bereitstellung von Aussparungen in der Top- oder Bottom-Elektrode
- **Fig. 8**: Schematische Darstellung von Schwächungsbereichen durch eine Strukturierung der Aktuatorlage
- **Fig. 9**: Schematische Darstellung von Schwächungsbereichen durch Bildung durchgehender Öffnungen

### Detaillierte Beschreibung der Figuren

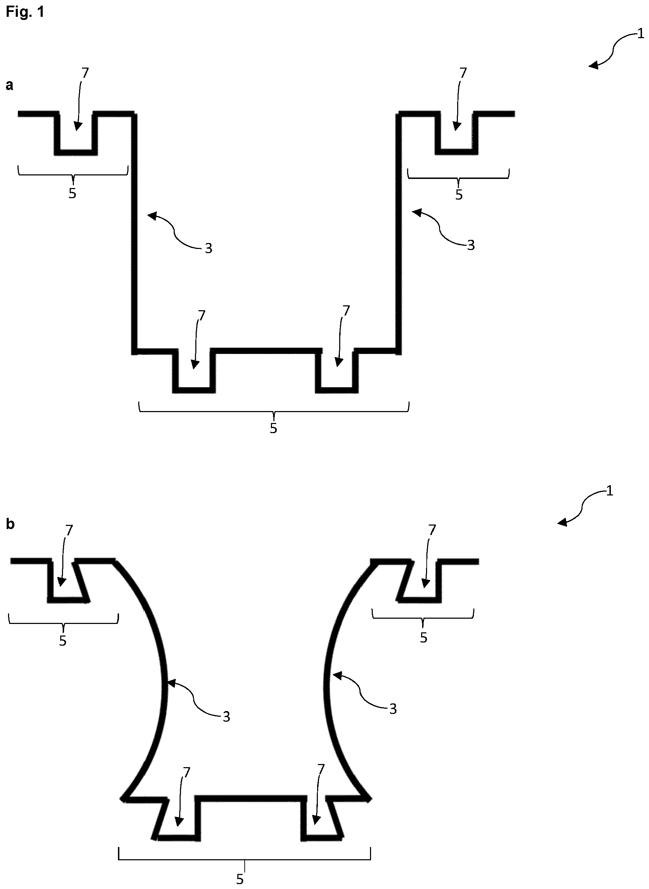

Fig. 1 a, b illustriert eine schwingfähige Membran 1 eines MEMS-Wandlers, welche an ihren vertikalen Abschnitten 3 und horizontalen Abschnitten 5 Korrugationen 7 aufweist.

In Fig. 1 a wird ein rechteckiger Querschnitt der Korrugationen 7 gezeigt, während die Fig. 1b einen trapezförmigen Querschnitt illustriert.

Vorteilhaft kann durch eine Ausgestaltung der geometrischen Form von einer oder mehreren Korrugationen **7** das Schwingungsverhalten der schwingfähigen Membran **1** optimiert werden.

Zum einen führen die Korrugationen **7** zu einem höheren Rotationsgrad der vertikalen Abschnitte **3,** wodurch eine besonders effiziente Auslenkbarkeit der schwingfähigen Membran gewähreistet wird. Zum anderen bewirken die Korrugationen vorteilhaft, dass bei der Erzeugung oder Aufnahme von Druckwellen die vertikalen Abschnitte eine besonders definierte Wölbung erfahren (vgl. Fig. 1b). Ein potentielles Auftreten unregelmäßiger Knickungen (*'buckling'*) wird besonders wirksam verhindert.

Weiterhin erlaubt eine gezielte Einbringung von Korrugationen **7** höhere Amplituden der horizontalen Schwingungen.

Hierdurch kommt es beispielsweise im Falle eines MEMS-Lautsprechers zu einer höheren Verdrängung des Fluidvolumens zwischen den vertikalen Abschnitten **3,** wodurch eine Steigerung des erzeugten Schalldruckpegels ermöglicht wird. Entsprechend kann im Falle eines MEMS-Mikrofons mehr Fluidvolumen zwischen den vertikalen Abschnitten aufgenommen und eine Sensitivität des Schalldetektors erhöht werden. Die besonders gleichmäßige Wölbung der vertikalen Abschnitte **7** während der horizontalen Schwingungen verringert zudem das Auftreten harmonischer Verzerrungen. Ein besonders gutes Klangbild sowohl bei der Aufnahme als auch bei der Erzeugung von Druckwellen eines Fluids resultiert.

Fig. 2 zeigt bevorzugte Verfahrensschritte zur Herstellung einer Ausführungsform eines erfindungsgemäßen MEMS-Wandlers.

In Fig. 2 a wird ein Substrats **9** illustriert, welches zuvor ausgehend von einer Vorderseite zur Ausbildung eine Strukturierung geätzt wurde. In dem Ätzprozess wurden zum einen parallele tiefe Trenches (Taschen) in das Substrat **9** geformt, sodass die geformte Struktur einen Faltenbalg bzw. im Querschnitt einen Mäander darstellt. Zum anderen wurde in dem Ätzprozess in Abschnitten des Substrates **9,** welche die horizontalen Abschnitte bilden werden, Erhebungen bzw. Vertiefungen zur Ausbildung der Korrugation bereitgestellt.

Fig. 2 b illustriert das Auftragen eines Ätzstops **11,** welcher als Opferschicht fungiert und die vertikalen Abschnitten **3** und/oder die horizontalen Abschnitten **5** bei der rückseitigen Ätzung zur Freistellung der Membran schützen soll.

Auf den Ätzstop **9** wird eine Lage aus einem mechanischen Stützmaterial **17** aufgebracht (Fig. 2 c). Bei dem mechanischen Stützmaterial **17** kann es sich vorzugsweise gleichzeitig um ein leitfähiges Material handeln, z. B. Polysilizium, sodass die Lage aus einem mechanischen Stützmaterial **17** gleichzeitig als Bottom-Elektrode fungieren kann.

In Fig. 2 d wird eine mittlere Lage umfassend ein Aktuatormaterial **15** auf die Lage aus einem mechanischen Stützmaterial **17** beschichtet. Bei dem Aktuatormaterial **15** kann es sich vorzugsweise um ein piezoelektrisches Material z.B. AIN handeln.

Anschließend wird in Fig. 2 e gezeigt, dass eine obere Lage umfassend ein leitfähiges Material **13** beschichtet wird, wobei die obere Lage **13** als Top-Elektrode fungieren wird.

Fig. 2 f zeigt die Auftragung eines Elektrodenpads zur Kontaktierung der oberen Lage aus einem leitfähigen Material **13,** welche als Top-Elektrode fungiert sowie der unteren Lage aus einem leitfähigen, mechanischen Stützmaterial **17,** welche als Bottom-Elektrode fungiert.

In Fig. 2 g wird das Substrat **9** von einer Rückseite geätzt, um die schwingfähige Membran **1** freizustellen und einen Träger **2** zu bilden. Der Träger **2** umfasst zwei Seitenbereiche, zwischen denen die schwingfähige Membran **1** in horizontaler Richtung angeordnet vorliegt. Die schwingfähige Membran 1 ist als Mäanderstruktur ausgebildet, wobei die Mäanderstruktur durch die vertikalen Abschnitte **3** und horizontalen Abschnitte **5** gebildet wird. Nach der Ätzung des Substrates weisen nunmehr die horizontalen Abschnitte **5** erfindungsgemäße Korrugationen **7** auf, welche zu einer deutlichen Verbesserung des Schwingungsverhalten der schwingfähigen Membran **1** führen.

Die in Fig. 2 h eingezeichneten Pfeile dienen der Darstellung der horizontalen Schwingungen der vertikalen Abschnitte **3.** Insbesondere wird durch die Anbringung von Korrugationen **7** die Rotationsfreiheit der vertikalen Abschnitte **3** erhöht, sodass vorteilhaft eine Optimierung des Schwingungsverhaltens der schwingfähigen Membran **1** erlangt werden kann.

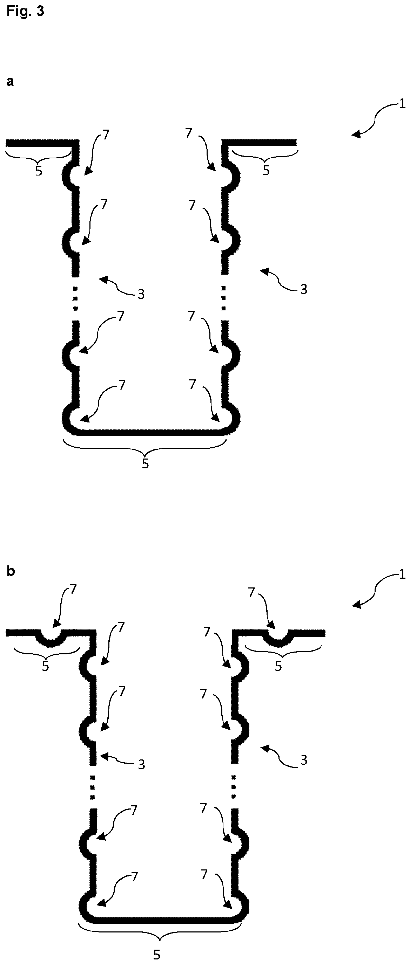

Fig. 3 zeigt weitere bevorzugte Ausführungsform einer schwingfähigen Membran **1** umfassend Korrugationen **7.** Die dargestellten Korrugationen **7** weisen einen runden, teilkreisförmigen Querschnitt auf.

In Fig. 3 a liegen die Korrugationen **7** an den vertikalen Abschnitten **3** angebracht vor. Durch die Anbringung von Korrugationen **7** an den vertikalen Abschnitten **3** wird vorteilhaft die Biegesteifigkeit gesenkt, sodass eine höhere Auslenkbarkeit der vertikalen Abschnitte **3** erreicht werden kann.

Fig. 3 b stellt die schwingfähige Membran **1** aus Fig. 3 a dar. Allerdings sind nunmehr auch Korrugationen **7** an den horizontalen Abschnitten **5** angebracht, was sich weiter vorteilhaft auf die Rotationsfreiheit der vertikalen Abschnitte **3** auswirkt.

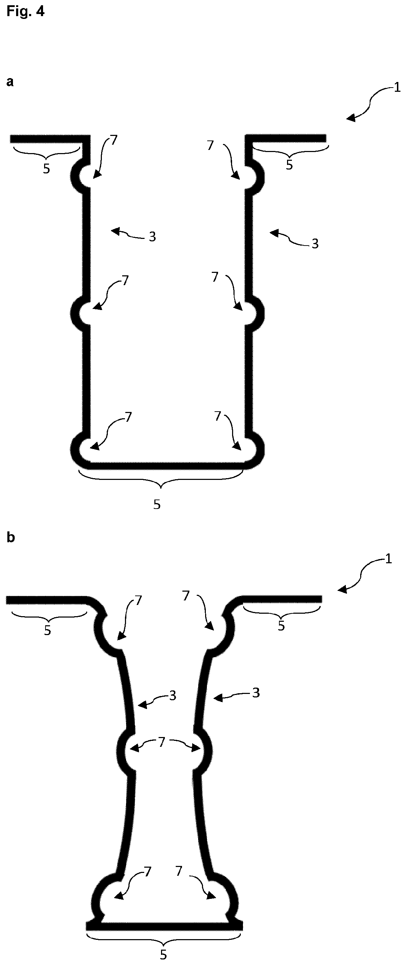

Fig. 4 zeigt eine schematische Darstellung von Korrugationen **7** an vertikalen Abschnitten **3** sowie nunmehr zusätzlich an den Verbindungsstellen zwischen horizontalen Abschnitten **5** und vertikalen Abschnitten **3.**

Während Fig. 4 a eine Ausgangslage der vertikalen Abschnitte 3 zeigt, zeigt Fig. 4 b eine Auslenkung der vertikalen Abschnitte 3, bspw. durch Ansteuerung einer Elektrode. Die Korrugationen **7** gewährleisten eine gleichmäßige Wölbung, ohne Risiko eines Auftretens von unregelmäßigen Knickungen (englisch *buckling).*

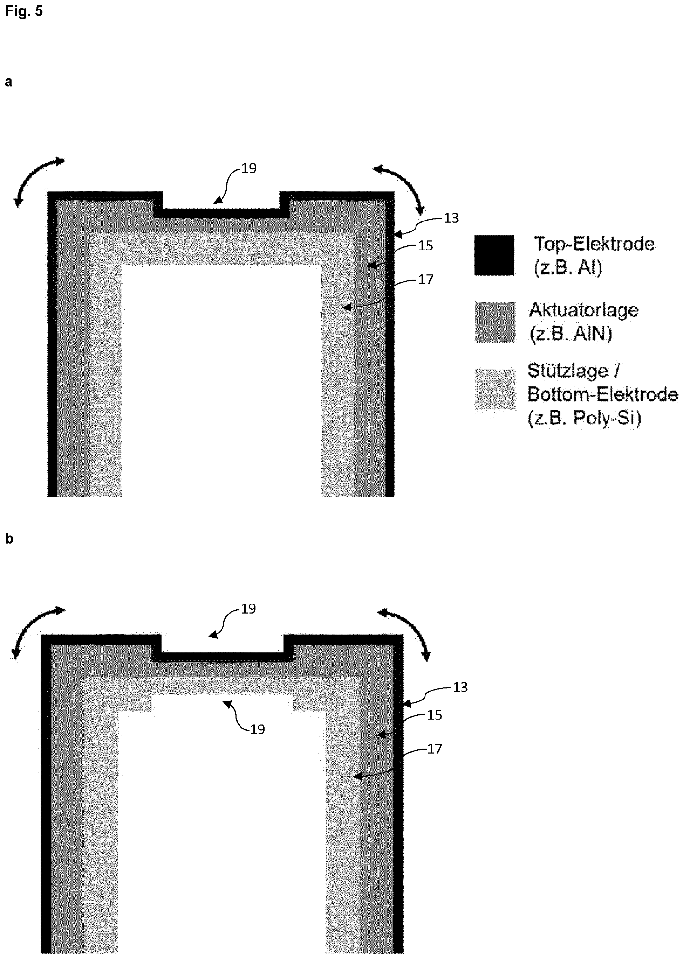

Fig. 5 zeigt eine bevorzugte Ausführungsform zur Ausbildung von Schwächungsbereichen **19** an horizontalen Abschnitten **5.**

In der bevorzugten Ausführungsform ist die Membran **1** mehrlagig ausgebildet. Eine untere Lage aus einem mechanischen Stützmaterial **17** wird aus einem leitfähigen Material (hier: Polysilizium) gebildet, sodass die untere Lage aus einem mechanischen Stützmaterial **17** gleichzeitig sowohl als Bottom-Elektrode als auch als Trägerschicht fungiert. Auf der Lage aus einem Stützmaterial **17** liegt eine mittlere Lage umfassend ein Aktuatormaterial **15** (hier: Aluminiumnitrid AIN als eine piezoelektrische Schicht) sowie eine obere Lage umfassend leitfähiges Material **13** (hier: Aluminium) vor, welche als Top-Elektrode fungiert.

In Fig. 5 a ist die Schichtdicke der mittleren Aktuatorlage **15** im Vergleich zur Ausgangschichtdicke bereichsweise zur Ausbildung eines Schwächungsbereiches **19** reduziert.

In Fig. 5 b wird zusätzlich zur Variation der Schichtdicke der mittleren Aktuatorlage **15** die Schichtdicke der unteren Stützlage **17** im Vergleich zur Ausgangschichtdicke bereichsweise zur Ausbildung eines Schwächungsbereiches **19** reduziert.

Vorteilhaft können durch Schwächungsbereiche **19** ähnliche Effekte in Bezug auf eine Optimierung des Schwingungsverhalten der vertikalen Abschnitte 3 erzielt werden, wie durch eine Anbringung von Korrugationen.

Insbesondere erlaubt die Einbringung von Schwächungsbereichen **19** eine Verringerung der Steifigkeit horizontaler Abschnitte **5,** sodass eine Auslenkbarkeit der vertikalen Abschnitte **3** erhöht wird. Die Pfeile in den Fig. 5 a und b illustrieren die resultierende verbesserte Bewegungs- bzw. Rotationsfreiheit der vertikalen Abschnitte **3.**

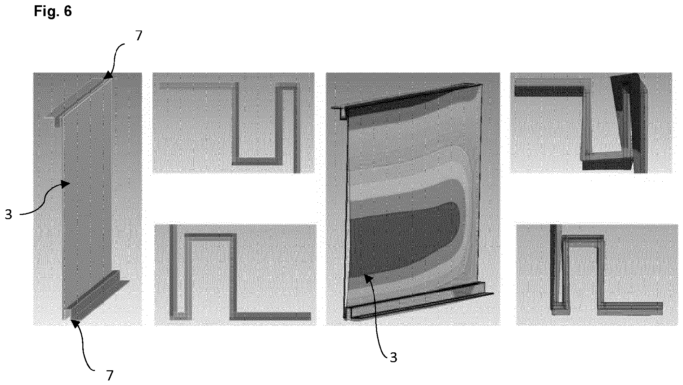

In Fig. 6 werden die Ergebnisse einer Simulation eines Schwingungsverhaltens eines vertikalen Abschnittes **3** bei Anbringung von Korrugationen **7** an angrenzenden horizontalen Abschnitten gezeigt.

Wie in der Fig. 6 deutlich wird, kann durch die Anbringung von Korrugationen **7** an horizontalen Abschnitten **5** die Rotationsfreiheit der vertikalen Abschnitte **3** erhöht werden, wodurch eine besonders gleichmäßige Wölbung der vertikalen Abschnitte **3** resultiert, ohne dass unregelmäßige Knickungen (engl. *buckling)* auftreten.

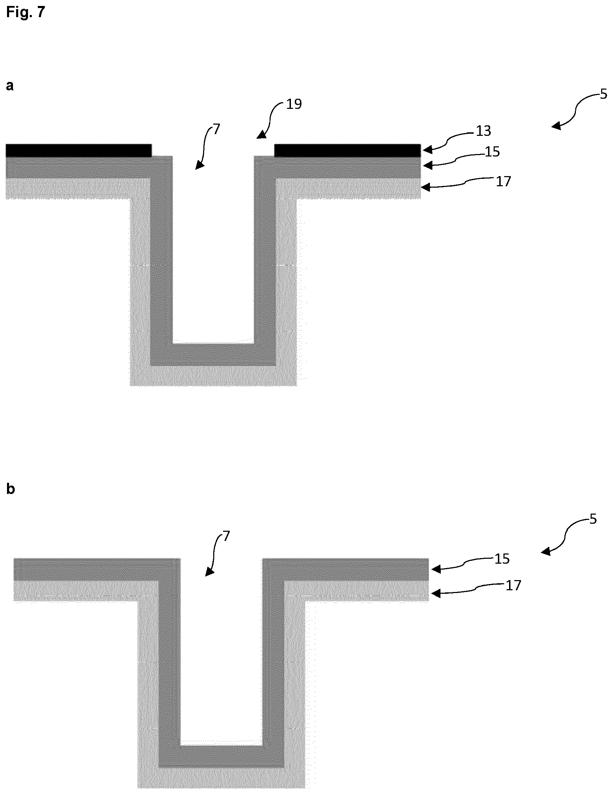

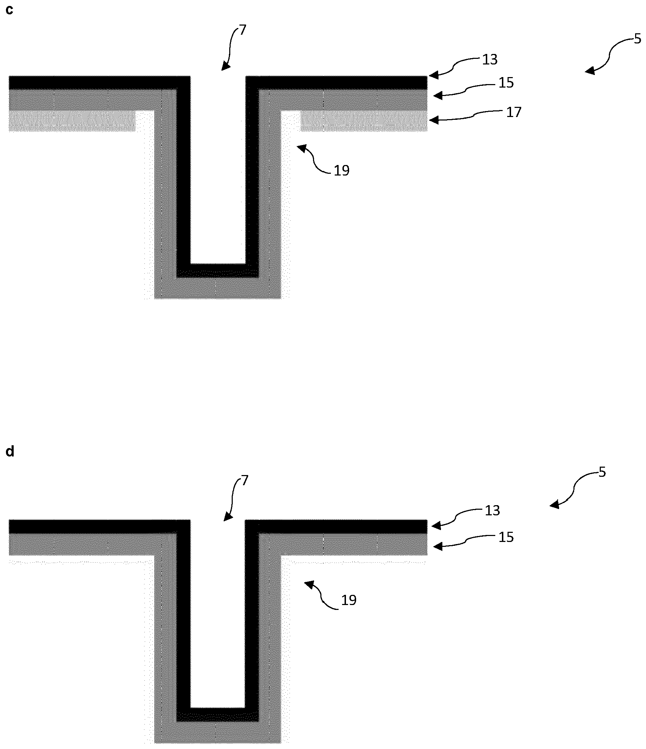

Fig. 7 zeigt eine schematische Darstellung für eine bevorzugte Bereitstellung von Schwächungsbereichen **19** durch Bereitstellung von Aussparungen in der Top- oder Bottom-Elektrode. Die Schwächungsbereiche **19** sind mithin durch eine bereichsweise Reduzierung einer Schichtdicke der Lage eines leitfähigen Materials **13** (Top- oder Bottom-Elektrode) auf 0 % gekennzeichnet.

Fig. 7 a zeigt einen Ausschnitt eines horizontalen Abschnitts **5** mit einer Korrugation **7.** Die Membran **1** umfasst eine obere Lage aus einem leitfähigen Material **13,** welches als Top-Elektrode fungiert, eine Aktuatorlage **15** umfassend ein Aktuatormaterial sowie eine untere Lage aus einem leitfähigen Material **13,** welches gleichzeitig als Stützlage **17** und Bottom-Elektrode fungiert. Der Schwächungsbereich **19** liegt derart vor, dass das leitfähige Material **13** bzw. die Top-Elektrode über den Bereich der Korrugation **7** fehlt. In dem Bereich, in dem die Top-Elektrode fehlt, kann im Gegensatz zum übrigen horizontalen Abschnitt **5** der Membran kein oder nur ein verringertes elektrisches Feld zwischen der Top- und Bottom-Elektrode ausgebildet sein. Die Aktuatorlage **15,** vorzugsweise umfassend ein piezoelektrisches Material, welches sich zwischen der Top- und Bottom-Elektrode befindet, wird mithin im Bereich der Aussparung der Top-Elektrode nicht oder in geringerem Maße zu einer Formänderungen angeregt bzw. aktuiert.

Die verringerte Aktuierung resultiert mithin aus einer lokalen Verringerung des piezoelektrischen Effektes an der betreffenden Stelle. Hierdurch kann vorteilhaft das Schwingungsverhalten der Membran optimiert werden, indem eine Beweglichkeit angrenzender vertikaler Abschnitte erhöht und/oder unerwünschte Effekte wie Knickungen (engl.: *Buckling)* vermieden werden.

Fig 7 b zeigt einen Ausschnitt einer Membran mit einer Korrugation **7** entlang eines horizontalen Abschnitts **5.** Die Membran umfasst eine Aktuatorlage **15** umfassend ein Aktuatormaterial, welche auf einer Lage aus einem leitfähigen Material **13** aufgebracht ist, welches gleichzeitig als Stützlage **17** fungiert. Hiermit wird ein Schwächungsbereich **19** derart bereitgestellt, dass das leitfähige Material **13** bzw. die Top-Elektrode nicht nur im Bereich der Korrugation **7,** sondern auch in übrigen Bereichen des horizontalen Abschnitts **5** fehlt.

Fig. 7 c und 7 d zeigen analoge Ausführungsformen wie die Fig. 7 a und b, allerdings wird der Schwächungsbereich **19** durch Aussparungen in der unteren Lage eines leitfähigen Materials **13,** gebildet welche sowohl als Bottom-Elektrode als auch als Stützlage 17 fungiert. Der Schwächungsbereich **19** liegt mithin derart vor, dass das leitfähige Material **13** bzw. die Bottom-Elektrode über den Bereich der Korrugation **7** fehlt. Neben dem Effekt eine reduzierten Aktuierung der Aktuatorlage **15,** trägt das Fehlen der Stützlage **17** zur einer Reduktion der Steifigkeit der Membran 1 in dem Bereich bei und erlaubt eine Optimierung des Schwingungsverhaltens.

In Fig. 7 c liegt der Schwächungsbereich **19** liegt derart vor, dass das leitfähige Material **13** bzw. die Top-Elektrode im Bereich der Korrugation **7** fehlt. In der Fig 7 d wird ein Schwächungsbereich derart bereitgestellt, dass das leitfähige Material **13** bzw. die Bottom-Elektrode nicht nur im Bereich der Korrugation **7,** sondern auch in übrigen Bereichen des horizontalen Abschnitts **5** fehlt bzw. ausgespart ist.

Vorzugsweise erstreckt sich die Aussparung der Lage aus einem leitfähigen Material **13** im Wesentlichen entlang der Dimension der Länge der flächigen Membran einer in den Abbildungen (nicht sichtbaren) Zeichnungstiefe. Es ist jedoch bevorzugt, dass Leiterbahnen oder verbleibende leitende Bereiche vorzusehen, welche eine endseitige Kontaktierung und durchgängigen Stromfluss in der Top- und/oder Bottom-Elektrode gewährleisten. So kann die Aussparung der Top- und/oder Bottom-Elektrode vorzugsweise im Wesentlichen entlang der gesamten Dimension der Länge der Membran vorliegen, wobei die Aussparung durch dünne (weniger als 20 µm, vorzugsweise weniger als 10 µm) leitende Bereiche oder Leiterbahnen unterbrochen wird. Um die Bildung der Schwächungsbereiche **19** zu illustrieren, wird in den Abbildungen vorzugsweise eine Querschnittsebene entlang der Dimension der Länge gezeigt, an denen die Aussparung sichtbar ist.

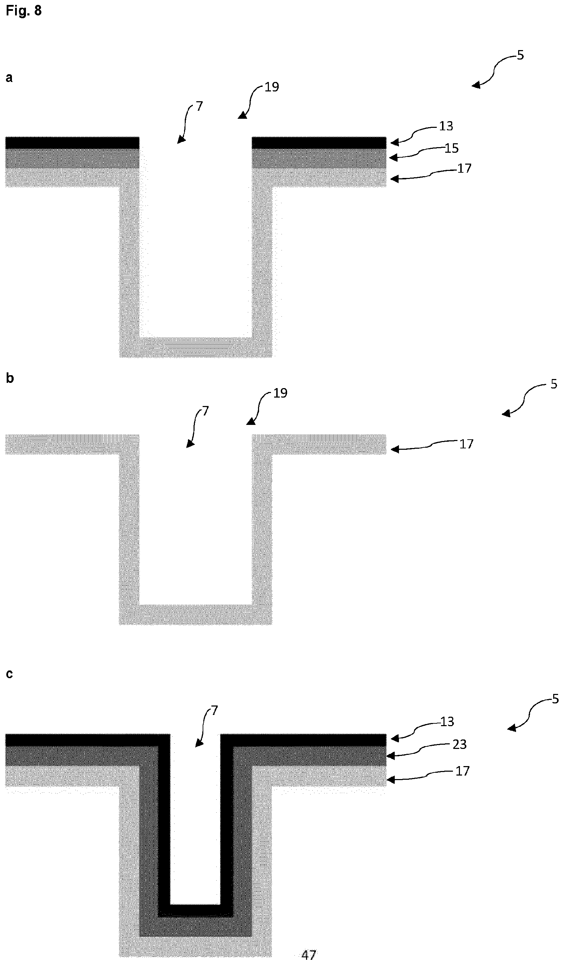

Fig. 8 zeigt eine schematische Darstellung für eine bevorzugte Bereitstellung von Schwächungsbereichen **19** durch Bereitstellung von Aussparungen in einer Aktuatorlage **15.** Die Schwächungsbereiche **19** sind mithin durch eine bereichsweise Reduzierung einer Schichtdicke mindestens der Lage **15** eines Aktuatormaterials auf 0 % gekennzeichnet.

In den gezeigten Ausführungsformen wird eine bereichsweise Reduzierung einer Aktuierbarkeit der mithin durch ein Strukturieren der Aktuatorlage **15** - beispielsweise einer piezoelektrischen Aktuatorlage **15** - bewirkt werden.

Fig. 8 a zeigt eine Ausführungsform, bei der der horizontale Abschnitt **5** der Membran ein Schwächungsbereich **19** über den Bereich der Korrugation **7** aufweist, indem eine Aktuatorlage **15** entlang der Korrugation **19** fehlt. Die obere Lage aus leitfähigem Material **13,** welche als Top-Elektrode fungiert, ist in dem Bereich ebenfalls ausgespart.

Fig 8 b zeigt einen Ausschnitt einer Membran mit einer Korrugation **7** entlang eines horizontalen Abschnitts **5.** Die Membran umfasst in dem Schwächungsbereich **19** lediglich eine Stützlage **17,** welche leitfähig ist und gleichzeitig als Bottom-Elektrode fungiert. Hiermit wird ein Schwächungsbereich **19** derart bereitgestellt, dass sowohl das leitfähige Material **13** bzw. die Top-Elektrode als auch das die Aktuatorlage **15** nicht nur im Bereich der Korrugation **7,** sondern auch in übrigen Bereichen des horizontalen Abschnitts **5** fehlt.

Fig. 8 c zeigt einen Ausschnitt einer Membran mit einer Korrugation **7** entlang eines horizontalen Abschnitts **5.** Die Membran umfasst eine untere Lage aus einem leitfähigen Material **13,** welches als Bottom-Elektrode und Stützlage **17** fungiert sowie eine obere Lage aus einem leitfähigen Material **13,** welches eine Top-Elektrode bildet. Zwischen den Lagen des elektrisch leitfähigen Materials fehlt die Aktuatorlage **15.** Stattdessen ist eine Isolationslage **23** eingebracht, welche durch ein dielektrisches Material gebildet wird. Auch in dieser Ausführungsform wird im Schwächungsbereich **19** eine Aktuierbarkeit der Membran **1** reduziert. Vorteilhaft ermöglicht der Austausch der Aktuatorlage **15** gegen eine Isolationslage **23** hierbei die Beibehaltung der gesamtheitlichen Dicke der Membran **15.** Zudem kann es bevorzugt sein, durch die dielektrische Schicht eine mechanische Stabilität der Membran auch im Schwächungsbereich **19** zu gewährleisten.

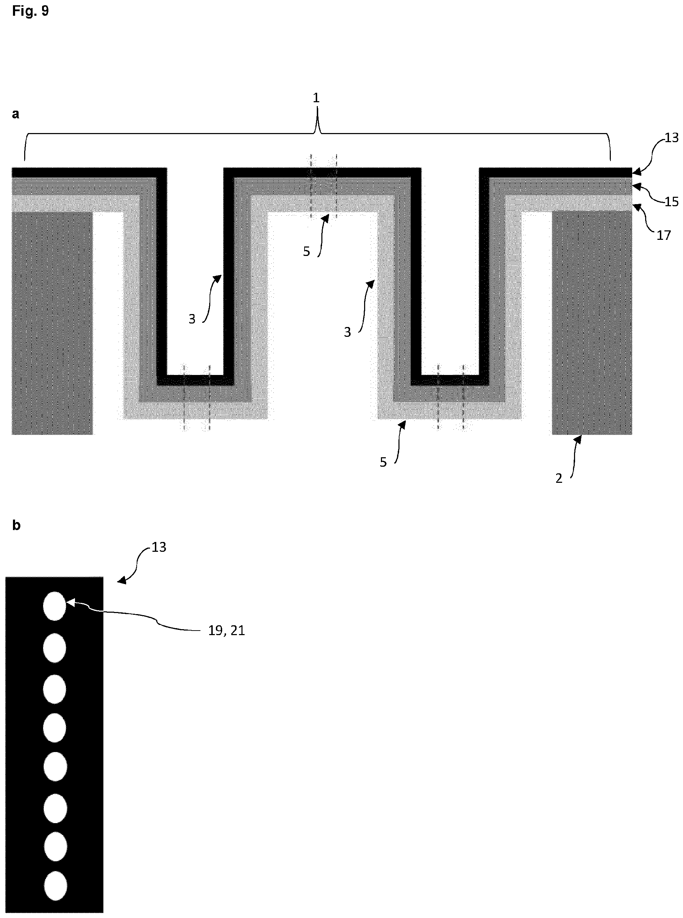

In Fig. 9 zeigt eine schematische Darstellung von Schwächungsbereichen **19** durch Bildung durchgehender Öffnungen **21.**

In Fig. 9 a wird der Querschnitt eines MEMS-Wandlers gezeigt, der eine Membran **1** umfassend vertikale Abschnitte **3** und horizontale Abschnitte **5** aufweist. Die Membran 1 erstreckt sich in horizontaler Richtung entlang eines Trägers **2,** an dem die Membran 1 aufgehangen ist. Die Membran **1** umfasst eine leitfähige Stützlage **17,** welche gleichzeitig als Bottom-Elektrode fungiert, eine Aktuatorlage **15** sowie darauf befindend eine obere Lage aus leitfähigem Material **13,** welche als Top-Elektrode dient. In Fig. 9 a sind weiterhin an den horizontalen Abschnitten **5** gestrichelte Linien eingezeichnet, die symbolisieren sollen, dass sich an diesen Stellen der horizontalen Abschnitte **5** durchgehenden Öffnungen als Schwächungsbereichen **19** befinden.

Die Schwächungsbereiche **19** werden mithin durch eine bereichsweise Reduzierung der Schichtdicke sämtlicher Lagen auf 0 % bereitgestellt.

Fig. 9 b zeigt eine Draufsicht des MEMS-Wandlers, wobei ersichtlich ist, dass Schwächungsbereiche **19** in Form von Öffnungen **21** in ein Reihe entlang der Dimension der Länge des horizontalen Abschnittes **5** aufgereiht sind. Die Top- und Bottom-Elektrode sind trotz der Öffnungen **21** weiterhin in der Fläche durchgängig leitfähig. Auch durch die Bereitstellung von Öffnungen **21** kann mithin eine Steifigkeit der horizontalen Abschnitte und/oder vertikalen Abschnitte lokal verringert werden kann, um das Schwingungsverhalten der Membran **1** zu optimieren. Die gewünschte Ausprägung der Reduktion der Steifigkeit kann insbesondere durch die geometrische Form der Öffnungen **21** und/oder der Anzahl der Öffnungen **21** eingestellt werden.

### LITERATUR

Bert Kaiser, Sergiu Langa, Lutz Ehrig, Michael Stolz, Hermann Schenk, Holger Conrad, Harald Schenk, Klaus Schimmanz und David Schuffenhauer, Concept and proof for an all-silicon MEMS microspeaker utilizing air chambers Microsystems & Nanoengineering volume 5, Article number: 43 (2019).
Iman Shahosseini, Elie LEFEUVRE, Johan Moulin, Marion Woytasik, Emile Martincic, et al. Electromagnetic MEMS Microspeaker for Portable Electronic Devices. Microsystem Technologies, Springer Verlag (Germany), 2013, pp.10. <hal-01103612>.
F. Stoppel, C. Eisermann, S. Gu-Stoppel, D. Kaden, T. Giese and B. Wagner, NOVEL MEMBRANE-LESS TWO-WAY MEMS LOUDSPEAKER BASED ON PIEZOELECTRIC DUAL-CONCENTRIC ACTUATORS, Transducers 2017, Kaohsiung, TAIWAN, June 18-22, 2017.

### BEZUGSZEICHENLISTE

- 1: Schwingfähige Membran
- 2: Träger
- 3: Vertikaler Abschnitt
- 5: Horizontaler Abschnitt
- 7: Korrugation
- 9: Substrat
- 11: Ätzstop
- 13: Lage aus einem leitfähigem Material
- 15: Lage aus einem Aktuatormaterial (Aktuatorlage)
- 17: Lage aus einem mechanischem Stützmaterial (Stützschicht bzw. Stützlage)
- 19: Schwächungsbereiche
- 21: Öffnung
- 23: Isolationslage bzw. Isolationsschicht

## Patentansprüche

1. MEMS-Wandler zur Interaktion mit einem Volumenstrom eines Fluids umfassend einen Träger (2) und eine schwingfähige Membran (1) zur Erzeugung oder Aufnahme von Druckwellen des Fluids in einer vertikalen Richtung, welche an dem Träger (2) befestigt und mit mindestens einer Elektrode kontaktiert vorliegt,
wobei die schwingfähige Membran (1) vertikale Abschnitte (3) und horizontale Abschnitte (5) aufweist, wobei die vertikalen Abschnitte (3) im Wesentlichen parallel zur vertikalen Richtung ausgebildet sind und die horizontalen Abschnitte (5) die vertikalen Abschnitte (3) miteinander verbinden,
sodass durch Ansteuerung der mindestens einen Elektrode die vertikalen Abschnitte (3) zu horizontalen Schwingungen anregbar sind oder sodass bei Anregung der vertikalen Abschnitte (3) zu horizontalen Schwingungen an der Elektrode ein elektrisches Signal erzeugbar ist,
**dadurch gekennzeichnet, dass**
die vertikalen Abschnitte (3) und/oder die horizontalen Abschnitte (5) eine oder mehrere Korrugationen (7) und/oder Schwächungsbereiche (19) aufweisen.

2. MEMS-Wandler nach dem vorherigen Anspruch
**dadurch gekennzeichnet, dass**
die eine oder mehrere Korrugationen (7) und/oder Schwächungsbereiche (19) entlang der horizontalen Abschnitte (5), entlang der vertikalen Abschnitten (3) und/oder an Verbindungsstellen zwischen vertikalen Abschnitten (3) und horizontalen Abschnitten (5) vorliegen.

3. MEMS-Wandler nach einem oder mehreren der vorherigen Ansprüche
**dadurch gekennzeichnet, dass**
entlang eines vertikalen Abschnitts (3) und/oder eines horizontalen Abschnitts (5) mindestens 1, 2, 3, 4, 5 oder mehr Korrugationen (7) und/oder Schwächungsbereiche (19) angebracht sind.

4. MEMS-Wandler nach einem oder mehreren der vorherigen Ansprüche
**dadurch gekennzeichnet, dass**
die eine oder mehrere Korrugationen (7) einen rechteckigen, trapezförmigen, quadratischen, dreieckigen, teilkreisförmigen und/oder runden Querschnitt aufweisen und/oder
die eine oder mehrere Korrugationen (7) eine Tiefe von 1 µm - 100 µm bevorzugt 2 µm - 20 µm und/oder eine Breite zwischen ca. 0,5 µm - 50 µm, bevorzugt zwischen 1 µm - 5 µm, aufweisen.

5. MEMS-Wandler nach einem oder mehreren der vorherigen Ansprüche
**dadurch gekennzeichnet, dass**
die eine oder mehreren Korrugationen (7) ein Aspektverhältnis von Breite zu Tiefe von 1:1 oder mehr, bevorzugt von 1:2 oder mehr aufweist.

6. MEMS-Wandler nach einem oder mehreren der vorherigen Ansprüche
**dadurch gekennzeichnet, dass**
die horizontalen Abschnitte (5) und/oder vertikalen Abschnitte (7) mehrlagig ausgebildet sind und wobei eine oder mehrere Schwächungsbereiche (19) durch eine Variation der Schichtdicke mindestens einer Lage bewirkt wird, wobei bevorzugt die Schichtdicke der mindestens einen Lage auf weniger als 70%, vorzugweise weniger als 60%, 50%, 40% oder weniger einer Ausgangsschichtdicke reduziert ist.

7. MEMS-Wandler nach einem oder mehreren der vorherigen Ansprüche
**dadurch gekennzeichnet, dass**
die horizontalen Abschnitte und/oder vertikalen Abschnitte mehrlagig ausgebildet sind und wobei eine oder mehrere Schwächungsbereiche durch eine bereichsweise Reduzierung einer Schichtdicke mindestens einer Lage auf 0 % gebildet werden, welche vorzugsweise eine Lage umfassend ein leitfähiges Material (13), eine Lage umfassend ein Stützmaterial (17) und/oder eine Lage umfassend ein Aktuatormaterial (15) ist.

8. MEMS-Wandler nach einem oder mehreren der vorherigen Ansprüche
**dadurch gekennzeichnet, dass**
durch eine Ausgestaltung der einen oder mehrere Korrugationen (7) und/oder Schwächungsbereiche (19), bevorzugt hinsichtlich einer Tiefe, Breite, Schichtdicke, Geometrie und/oder Anzahl, eine Steifigkeit der horizontalen Abschnitte (5) und/oder vertikalen Abschnitte (7) einstellbar ist, um ein Schwingungsverhalten der vertikalen Abschnitte (5) zu optimieren.

9. MEMS-Wandler nach einem oder mehreren der vorherigen Ansprüche
**dadurch gekennzeichnet, dass**
die Einbringung von einer oder mehrere Korrugationen (7) und/oder Schwächungsbereichen (19) an den horizontalen Abschnitten (5) und/oder vertikalen Abschnitten (3) eine Rotationsfreiheit der vertikalen Abschnitte (3) erhöht, um ein Schwingungsverhalten der vertikalen Abschnitte (5) zu optimieren.

10. MEMS-Wandler nach einem oder mehreren der vorherigen Ansprüche
**dadurch gekennzeichnet, dass**
die eine oder mehrere Korrugationen (7) vertikalen Abschnitten (7) und/oder an Verbindungsstellen zwischen vertikalen Abschnitten (3) und horizontalen Abschnitten (5) vorliegen, wobei bevorzugt die eine oder mehrere Korrugationen (7) durch einen Ätzprozess während einer Formung vertikaler Trenches für die vertikalen Abschnitte (3) bereitstellbar sind.

11. MEMS-Wandler nach einem oder mehreren der vorherigen Ansprüche
**dadurch gekennzeichnet, dass**
der MEMS-Wandler ein MEMS-Lautsprecher ist, wobei bevorzugt zwischen den vertikalen Abschnitten (3) Luftvolumina vorliegen, welche durch die horizontalen Schwingungen zur Erzeugung von Schallwellen entlang einer vertikalen Emissionsrichtung bewegt werden
oder der MEMS-Wandler ein MEMS-Mikrofon ist, wobei bevorzugt zwischen den vertikalen Abschnitten (3) Luftvolumina vorliegen, welche bei Aufnahme von Schallwellen entlang einer vertikalen Detektionsrichtung bewegt werden.

12. MEMS-Wandler nach einem oder mehreren der vorherigen Ansprüche
**dadurch gekennzeichnet, dass**
die schwingfähige Membran (1) mindestens zwei Lagen umfasst, wobei beide Lagen ein Aktuatormaterial (15) umfassen und mit jeweils einer Elektrode kontaktiert vorliegen und die horizontalen Schwingungen durch eine Formänderung der einen Lage gegenüber der anderen Lage erzeugbar sind oder
die horizontale Schwingungen zu einer Formänderung der einen Lage gegenüber der anderen Lage führen und ein elektrisches Signal erzeugen.

13. MEMS-Wandler nach einem oder mehreren der vorherigen Ansprüche
**dadurch gekennzeichnet, dass**
die schwingfähige Membran (1) mindestens zwei Lagen umfasst, wobei eine erste Lage umfassend ein Aktuatormaterial (15) und eine zweite Lage ein mechanisches Stützmaterial (17) umfasst, wobei mindestens die erste Lage umfassend das Aktuatormaterial (15) mit der Elektrode kontaktiert vorliegt,
sodass horizontale Schwingungen durch eine Formänderung der Aktuatormaterials gegenüber dem mechanischen Stützmaterial erzeugbar sind oder
sodass horizontale Schwingungen zu einer Formänderung des Aktuatormaterials gegenüber dem mechanischen Stützmaterial führen und ein elektrisches Signal erzeugen.

14. MEMS-Wandler nach einem oder mehreren der vorherigen Ansprüche
**dadurch gekennzeichnet, dass**
die schwingfähige Membran (1) drei Lagen umfasst, wobei eine obere Lage von einem leitfähigen Material (13) gebildet wird und als Top-Elektrode fungiert, eine mittlere Lage (15) von einem Aktuatormaterial gebildet wird und eine untere Lage von einem leitfähigen Material (13) gebildet wird und als Bottom-Elektrode fungiert, wobei das leitfähige Material der oberen und/oder untere Lage bevorzugt ein mechanisches Stützmaterial (17) ist.

15. Verfahren zur Herstellung eines MEMS-Wandlers nach einem oder mehreren der vorherigen Ansprüche umfassend folgende Schritte:
- Ätzen eines Substrats (9), vorzugsweise von einer Vorderseite, zur Ausbildung einer Strukturierung, vorzugsweise einer Mäanderstruktur, und zur vorzugsweisen Ausbildung von Korrugationen (7),
- optionales Auftragen eines Ätzstops (11),
- Aufbringen mindestens zweier Lagen, wobei mindestens eine erste Lage ein Aktuatormaterial (15) und eine zweite Lage ein mechanischen Stützmaterial (17) umfassen oder mindestens zwei Lagen ein Aktuatormaterial (15) umfassen, wobei vorzugsweise im Prozess der Aufbringung der mindestens zweier Lagen oder durch ein nachträgliches Ätzen einer oder mehrere Schwächungsbereiche (19) bereitgestellt werden.
- Kontaktieren der ersten und/oder zweiten Lage mit einer Elektrode
- Ätzen des Substrats (9), vorzugsweise von der Rückseite, und optionale Entfernung des Ätzstops (11),
sodass die schwingfähige Membran (1) zur Ausführung von Schwingungen an dem Träger (2) befestigt wird,
wobei die schwingfähige Membran (1) vertikale Abschnitte (3) und horizontale Abschnitte (5) aufweist, wobei die vertikalen Abschnitte (3) im Wesentlichen parallel zur vertikalen Richtung ausgebildet sind und die horizontalen Abschnitte (5) die vertikalen Abschnitte (3) miteinander verbinden,
wobei die vertikalen Abschnitte (3) und/oder die horizontalen Abschnitte (5) eine oder mehrere Korrugationen (7) und/oder Schwächungsbereiche (19) aufweisen,
sodass durch Ansteuerung der Elektrode die vertikalen Abschnitte (5) zu horizontalen Schwingungen angeregt oder bei Anregung der vertikalen Abschnitte (5) zu horizontalen Schwingungen an der Elektrode ein elektrisches Signal erzeugt werden kann.
